(19) Europäisches Patentamt
European Patent Office
Office européen des brevets

(11) **EP 1 638 079 B1**

(12) **EUROPEAN PATENT SPECIFICATION**

(45) Date of publication and mention
of the grant of the patent:
**05.12.2018 Bulletin 2018/49**

(21) Application number: **05020108.6**

(22) Date of filing: **15.09.2005**

(51) Int Cl.:
***G10K 11/178*** (2006.01)

(54) **Method and system for active noise cancellation**

Verfahren und System zur aktiven Geräuschminderung

Procédé et système pour la suppression active du bruit

(84) Designated Contracting States:
**CH DE DK FR GB LI**

(30) Priority: **15.09.2004 CA 2481629**
**01.07.2005 US 173355**

(43) Date of publication of application:
**22.03.2006 Bulletin 2006/12**

(73) Proprietor: **Semiconductor Components
Industries, LLC
Phoenix, AZ 85008 (US)**

(72) Inventors:
• **Sheikhzadeh Nadjar, Hamid
Waterloo
Ontario N2K 4B4 (CA)**
• **Schneider, Todd
Waterloo
Ontario N2L 5M3 (CA)**
• **Brennan, Robert L.
Kitchener
Ontario N2N 3H9 (CA)**

(74) Representative: **Manitz Finsterwald Patentanwälte
PartmbB
Postfach 31 02 20
80102 München (DE)**

(56) References cited:
**CA-A1- 2 397 080       CA-A1- 2 397 084
CA-A1- 2 410 749       CA-A1- 2 437 477**

EP 1 638 079 B1

**Description**

FIELD OF INVENTION

The present invention relates to signal processing and modeling technique, and more specifically to signal processing and modeling technique for noise cancellation.

BACKGROUND OF THE INVENTION

Analog active noise cancellation (ANC) systems suffer from a number of problems. Specifically, they are prone to acoustic feedback, and they do not provide as high a degree of cancellation for periodic or other quasi-stationary signals as can be realized with a digital signal processing (DSP) enhanced analog ANC system.

Analog ANC systems are also difficult to adjust (or "tune") for different headset designs and also in a production environment where normal production variations in transducers and listening device assembly increase the likelihood of acoustic feedback.

Further, current analog ANC techniques address only part of the noise cancellation that is needed by users in high noise environments. Specifically, analog ANC provides noise cancellation at predominantly low frequencies (below 1500 Hz to 2000 Hz).

Fully digital ANC systems are possible. However, group delay or latency is induced by analog to digital (A/D) conversion, digital to analog conversion and digital processing associated with DSP systems. Further, due to power consumption, they are not practical in many portable applications.

U.S. Patent Nos. 5,475,761, 5,699,436, and 5,815,582 by Noise Cancellation Technologies (NCT) disclose methods of digital ANC using a combination of both feedback and feed-forward methods. The methods employ DSP to perform ANC, However, due to the inherent delay in the DSP, they are not practical for most applications when low-power, low-cost, and small-size constraints are applied. There are many other similar DSP-based systems that suffer from the same delay problem, for example, the systems disclosed in U.S. Patent Nos. 6,418,227 B1, 5,991,418 and 5,940,519 by Kuo et al. from Texas Instruments Inc.

U.S. Patent Nos. 6,069,959 and 6,118,878 byNCT disclose fully analog solutions to the ANC problems. Specifically, as U.S. Patent No. 6,118,878 explains, significant tuning and adaptation of the system parameters are necessary to avoid instability and artifacts. However, the patent suggests that the tuning can be implemented using analog components and methods.

Canadian Patent Application No. CA 2 397 080 A1 discloses sub-band adaptive signal processing in accordance with the preamble of claim 1.

In Canadian Patent Application No. CA 2 410 749 A1 a method and system for improving the convergence properties of adaptive filters is disclosed.

Canadian Patent Application No. CA 2 437 477 A1 also discloses a method and system for processing subband signals using adaptive filters.

Canadian Patent application CA 2 397 084 discloses an ANC system with a a sub-band processing module that can be implemented by combining analog and digital signal processing.

DSP-controlled ANC systems have tried to address the difficult problem of tuning of the analog ANC systems through the use of CPUs and signal processing methods. For example, U.S. Patent 5,440,642 by Denenberg et al. discloses DSP techniques that can control ANC system parameters, such as loop gain and loop filter frequency response. U.S. Patent Application Publication No. 20040037430 A1 uses DSP techniques (LMS adaptation) to control the secondary path typically used in the filtered-X LMS algorithm. U.S. Patent No. 4,965,832 uses DSP control of a feed-forward ANC system to control the loop-gain and the loop-filter bandwidth. U.S. Patent No. 6,278,786 B1 uses DSP to not only control the loop-gain but also to provide an acoustic signal (to be added to the analog ANC anti-noise) that will cope with tonal noises more effectively.

Subband adaptive filters (SAFs) become an interesting and viable option for many adaptive systems. The SAF approach uses a filterbank to split the fullband signal input into a number of frequency bands, each serving as input to an adaptive filter. This subband decomposition greatly reduces the update rate and the length of the adaptive filters resulting in much lower computational complexity.

To be able to employ powerful SAF method for ANC, one has to tackle a processing delay issue.

To reduce the processing delay in the SAFs, U.S. Patent No. 5,329,587 by Morgan et al, has introduced a method of reconstructing the subband filter back into time-domain. Starting with adapted subband filters, they first transform the SAFs into the frequency-domain (using an FFT), appropriately stack the results, and inverse transform them back into time-domain to obtain a time-domain adaptive filter. The time-domain filter is then used to implement time-domain adaptive filtering. The details of their technique are also reported in a research paper Morgan et. al. ("A delayless subband adaptive filter structure", IEEE Trans. on Signal Proc., Vol. 43, pp. 1819-1830, Aug. 1995) that offers a good survey of previous efforts on low-delay adaptive systems. Let us call this method DFT-1 Stacking as disclosed in J. Huo et al. ("New weight transform schemes for delayless subband adaptive filtering", in Proc. of IEEE Global Telecom. Conf., pp. 197-201,2001). After analyzing Morgan's method in by J. Huo et al., they offer two variations to the method (known as "DFT-2 Stacking" and "DFT-FIR Stacking") to improve the performance. These methods are all based on DFT, proper stacking, and inverse DFT. In DFT-FIR, a convolution with a synthesis filter after DFT is also added. Moreover in L. Larson et al. ("A new subband weight transform for delayless subband adaptive filtering structures", in Proc. of IEEE DSP workshop, pp. 201-206), a Linear Weight Transform method is introduced. The method employs a linear matrix transformation of the subband filters using both analysis and synthesis filters to recover the time-domain adaptive filter. In yet another set of works following Morgan's method, a different method is proposed that employs the Hadamard transform to reconstruct the time-domain filter (N. Hirayama and H. Sakai, "Analysis of a delayless subband adaptive filter", in Proc, of ICASSP, pp. 2329-2332, 1997; and N, Hirayama et al., "Delayless subband adaptive filtering using the hadamard transform", IEEE Trans. on Signal Proc., Vol. 47, No, 6, pp. 1731-1734, Jun. 1999).

In a series of research paper presented from 1997 to 1999, Merched et al. present methods of transferring the SAFs to time-domain (R. Merched et al. "A Delayless alias-free subband adaptive filter structure", in Proc. of IEEE Int. Symp. On Circuits and Systems, pp. 2329-2332, Jun. 9-12, 1997; P. S. R. Diniz et al. "Analysis of a delayless subband adaptive filter structure", in Proc. of ICASSP, pp. 1661-1664, 1998; R. Merched et al. "A new delayless subband adaptive filter structure", IEEE Trans. on Signal Proc., Vol. 47, No. 6, pp. 1580-1591, Jun. 1999). Their methods are designed only for maximally decimated (QMF) PR filterbanks, and constraints the filterbank prototype filter to be a Nyquist(K) filter (where K represents number of subbands). As a result, the SAFs become simple fractional delay filters. They also use a polyphase fiterbank to reconstruct the time-domain adaptive filter.

U. S. Patent No. 6,661,895 B1 by Jin et al. discloses a zero-delay SAF system. They discard the initial segment of each SAF to obtain a "forward filter". The estimated (time-domain) echo signal is generated by filtering the reference signal through the subband forward filters and then applying subband reconstruction. The time-domain echo cancelled signal goes through another separate time-domain LMS filter to compensate for the discarded initial segments of subband adaptive filters. The method however has a fundamental problem: the time-domain LMS filter has to model a potentially non-causal filter. This is not practically possible.

Over-sampled subband adaptive filters (OS-SAF) offer many advantages over time-domain adaptive algorithms. However, OS-SAF systems may introduce a group delay or latency that is too high for some applications. The conversion from analog to digital and back again, use of anti-aliasing and anti-imaging filters, as well as the digital processing introduces this delay. Reducing the delay of OS-SAF systems by increasing the sampling rate is not practical in many applications because of power consumed and specialized hardware required.

Also, in the conventional OS-SAF systems, the primary input signal goes through analysis and synthesis stages of the over-sampled filterbank. Often, perfect reconstruction (PR) is not practical and only a near PR performance is achieved. As a result, the primary signal may be distorted. To minimize distortions, longer analysis windows have to be employed which further increases the delay and add extra computation cost.

Further, in the conventional OS-SAF systems, the effect of analysis filter band edges and under-modeling errors limit the system performance.

## SUMMARY OF THE INVENTION

It is an object of the invention to provide a novel method and system that obviates or mitigates at least one of the disadvantages of existing systems.

It is an object of the invention to provide an improved method and system for active noise cancellation.

The invention relates to the improvements that can be made to well-known analog ANC techniques as well as over-sampled subband adaptive filtering using specialized DSP methods and apparatuses.

The object of the present invention is solved by the subject matter of the independent claims.

According to the present invention, there is provided a system for active noise cancellation, includes: an over-sampled analysis filterbank for transferring a primary signal in a time-domain, which is associated with an acoustic signal and may be contaminated by noise, into a plurality of subband primary signals in a frequency-domain; a subband processing module for the subband primary signals and implementing one or more than one subband adaptive algorithm in frequency-domain; and an over-sampled synthesis filterbank for transferring the outputs of the subband processing module into a time-domain output signal. The system of the invention is characterized by an analog active noise cancellation (ANC) system for performing an active noise cancellation to the primary signal in the time-domain and by the subband processing module including means for implementing the adaptive algorithm for adjusting one or more than one parameter of the analog ANC system.

This summary of the invention does not necessarily describe all features of the invention.

## BRIEF DESCRIPTION OF THE DRAWINGS

These and other features of the invention will become more apparent from the following description in which reference is made to the appended drawings wherein:

FIGURE 1(a) is a diagram showing a conventional analog ANC system;

FIGURE 1(b) is a diagram showing a detailed block diagram of Figure 1(a), depicting a transfer function and an acoustic transfer function;

FIGURE 2 is a diagram showing a conventional bSP-based ANC system;

FIGURE 3 is a diagram showing a subband ANC system using a subband FX-LMS;

FIGURE 4 is a diagram showing a subband ANC system using a subband FX-LMS;

FIGURE 5 is a diagram showing a conventional feedback ANC system using a subband FX-LMS;

FIGURE 6 is a diagram showing a subband feedback ANC system using a subband FX-LMS;

FIGURE 7 is a diagram showing a delayless subband ANC system using a FX-LMS;

FIGURE 8 is a diagram showing a delayless subband feedback ANC system using a FX-LMS;

FIGURE 9 is a diagram showing an ANC system using over-sampled subband processing in accordance with a further embodiment of the present invention;

FIGURE 10 is a diagram showing a feedback ANC system using over-sampled subband processing in accordance with a further embodiment of the present invention;

FIGURE 11 is a diagram showing an ANC system using Weighted Overlap-Add (WOLA) in accordance with a further embodiment of the present invention;

FIGURE 12 is a diagram showing a feedback ANC system using WOLA in accordance with a further embodiment of the present invention;

FIGURE 13 is a diagram showing an ANC system using WOLA in accordance with a further embodiment of the present invention;

FIGURE 14 is a diagram showing a conventional OS-SAF system;

FIGURES 15(a)-(b) are diagrams showing examples of an adaptive processing block (APB);

FIGURE 16 is a diagram showing an OS-SAF having WOLA;

FIGURE 17 is a diagram showing an OS-SAF system using over-sampled subband processing;

FIGURE 18 is a diagram showing an OS-SAF system using over-sampled subband processing;

FIGURE 19 is a diagram showing an OS-SAF system using WOLA in accordance with a further embodiment of the present invention;

FIGURE 20 is a diagram showing a closed-loop OS-SAF system using over-sampled subband processing;

FIGURE 21 is a diagram showing a closed-loop OS-SAF system using WOLA;

FIGURE 22 is a diagram showing a delayless subband feedback ANC system using WOLA;

FIGURE 23 is a diagram showing a delayless SAF system using oversampled filterbanks, employing weight transform for time-filter reconstruction;

FIGURE 24 is a diagram showing a Reconstruction of TAF through WOLA synthesis of the SAFs;

FIGURE 25 is a diagram showing details of time-filter reconstruction using the WOLA process;

FIGURE 26 is a diagram showing an oversampled SAF system applied to echo cancellation;

FIGURE 27 is a graph for showing the simulation results of Figures 24-26;

FIGURE 28 is a graph showing the ERLE results;

FIGURE 29 is a graph showing an example of real and imaginary parts of SAFs;

FIGURE 30 is a graph showing an example of periodic extension of a WOLA synthesis;

FIGURE 31 is a graph showing an example of a synthesis window;

FIGURE 32 is a graph showing the result of widow application of Figure 31;

FIGURE 33 is a graph showing an example of time sample for synthesizing a time-domain filter;

FIGURE 34(a) is a graph showing an example of time sample for a synthesized time-filter super-imposed on the ITUT plant;

FIGURE 34(b) is a graph showing an example of time-domain difference between the synthesized time-filter and the ITUT plant; and

FIGURE 35 is a graph showing echo attenuation of a time-domain filter and a conventional SAF.

DETAILED DESCRIPTION

The embodiments of the present invention are described for a headset. However, the embodiments of the present invention are applicable to any other listening devices, such as portable listening devices. The embodiments of the present invention are described mostly for active noise cancellation and echo cancellation. However, the embodiments of the present invention can be employed for other applications, including adaptive noise cancellation.

The embodiments of the present invention relate to over-sampled subband adaptive filtering using specialized DSP techniques and analog ANC techniques. Thus, DSPs are relevant to the technology disclosed below. Because the applications of these techniques are in listening devices and the cancellation relies on acoustic summation, the embodiments of the present invention relates to acoustics.

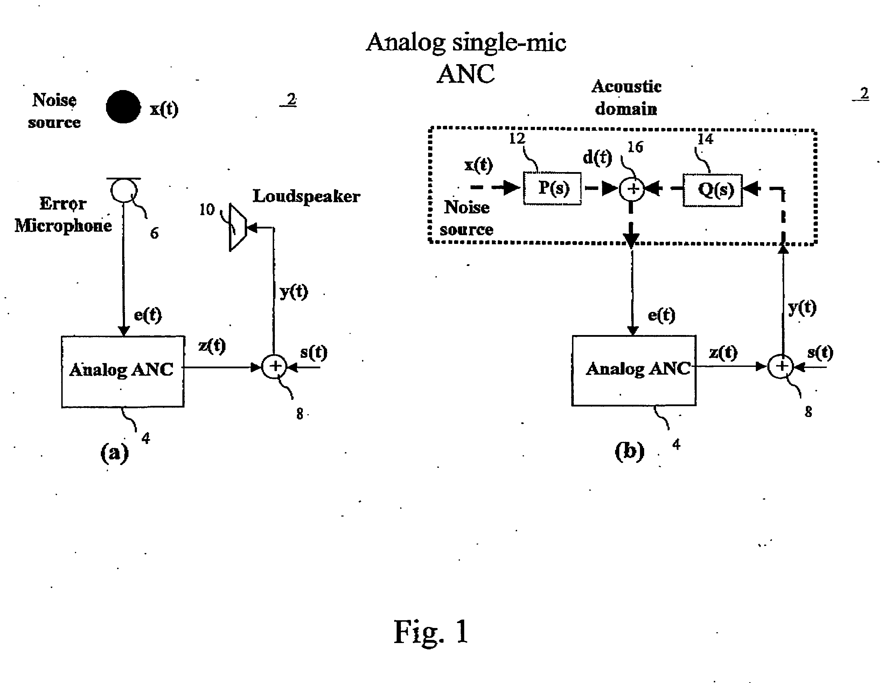

Figure 1(a) illustrates a conventional analog ANC system 2 for a headset. As shown in Figure 1(a), a primary noise signal x(t) is sensed by a microphone 6. The microphone 6 is usually located within the earcup of the headset For example, the primary noise signal x(t) is a signal outside the earcup of the headset. An analog ANC circuitry 4 receives the microphone signal e(t), and generates an electric signal z(t). The electric signal z(t) is added at 8 with a local audio signal s(t) (possibly speech) to generate an electric speaker signal y(t). The electric speaker signal y(t) is played through a loudspeaker 10 for the listener. The loudspeaker 10 is located within the earcup of the headset. The ANC system 2 tries to cancel the effect of a noise signal for the listener through estimating, generating the signal z(t) to be played through the loudspeaker 10 together with the local audio signal s(t).

Figure 1(b) illustrates modeling of a transfer function and an acoustic transfer function of Figure 1(a). P(s) 12 models the transfer function for the acoustic noise signal x(t) to be converted to an electric signal d(t). Q(s) 14 models the acoustic transfer function for the loudspeaker signal y(t) to reach the microphone (6). Usually Q(s) 14 is assumed to be more known than P(s) 12 since the locations of the loudspeaker (10) and the microphone (6) are fixed and known. A through review of the conventional analog ANC system 2 is provided in Kuo-Morgan99 (Sen M. Kuo and Dennis R. Morgan, "Active Noise Control: A Tutorial Review", Proceedings of the IEEE, VoL 87, June 1999, pp. 943-973).

ANC systems may also provide one or more microphones to measure the ambient noise (e.g. signal x(t) outside of the earcup), however, single microphone systems are generally preferred as discussed later.

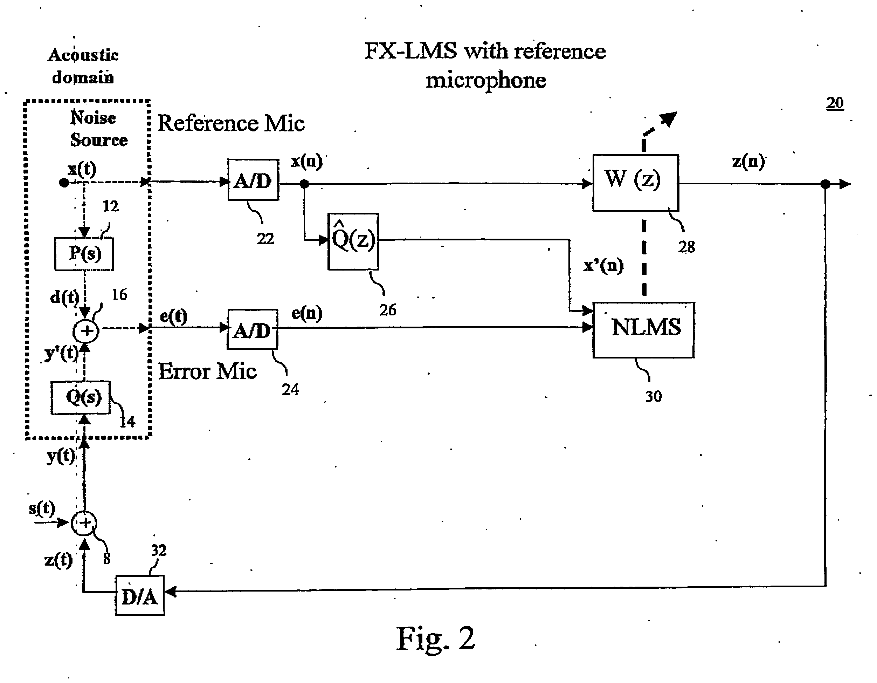

Figure 2 illustrates a conventional DSP-based ANC system 20. The system 20 of Figure 2 is a feedforward ANC system, and employs the FX LMS algorithm for active noise cancellation with two microphones. The two microphone signals x(t), e(t) are converted to digital signals x(n), e(n) by analog/digital (A/D) converters 22 and 24, and processed in discrete-time by an algorithm to generate an anti-noise signal z(n). The anti-noise signal z(n) is converted back to an analog signal z(t) by a digital/analog (D/A) converter 32, and played through the loudspeaker together with the signal s(t). The method might employ adaptive methods, such as the Normalized Least Mean Square (NLMS) 30 or similar techniques to adapt an adaptive filter W(z) 28. A rough estimate of the loudspeaker to the error microphone transfer function Q(s) is also required. In Figure 2, this is depicted by the discrete-time estimated transfer function $\hat{Q}(z)$ 26. Various methods for off-line on-line estimation of Q(s) have been proposed in the prior art and reviewed in Kuo-Morgan99.

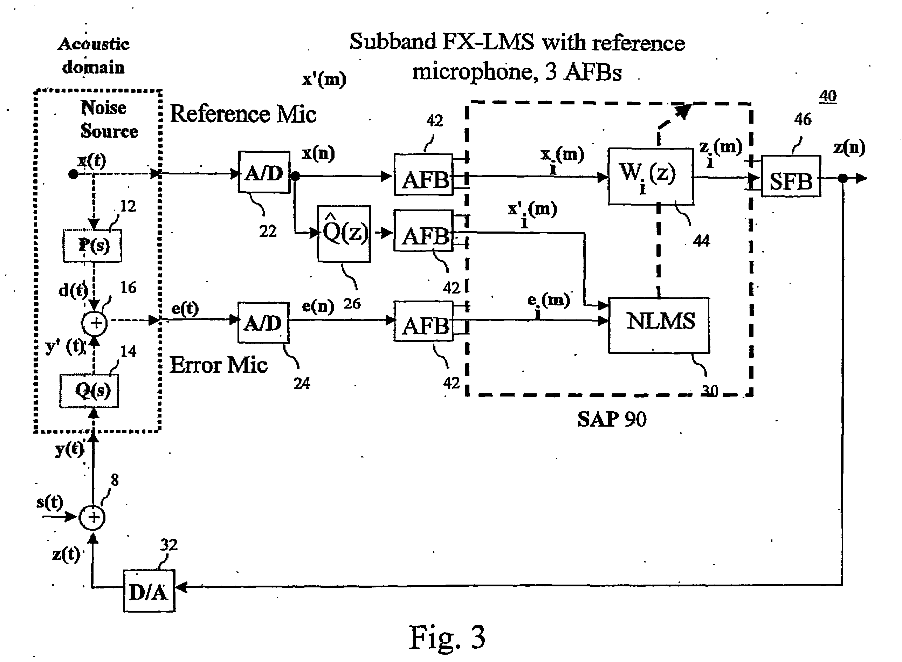

Subband ANC methods have been presented in Kuo-Morgan99 to achieve lower computation cost and faster convergence, Figure 3 illustrates a conventional subband ANC system for two microphones, employing a subband FX-LMS,

The system 40 of Figure 3 includes three Analysis Filter Bank (AFB) components 42. The AFB components 42 decompose the time-domain signals e(n), x(n), x'(n) into K (possibly complex) subband signals $e_i(m)$ $x_i(m),x_i'(m)$, i = 0,1,...,K-1 that might be also decimated in time. There exist K (possibly complex) subband adaptive filers (SAFs) Wi(z) 44 ($W_i(z)$, i = 0,1,.,., K-1) which generate subband output signals $z_i(m)$, i = 0,1,..., K-1. All of the adaptive processing is done in a subband adaptive processing (SAP) block 90 in Figure 3. A Synthesis Filter Bank (SFB) 46 then combines the subband output signals to obtain the time domain signal z(n). The D/A converter 32 converts the time domain, digital signal z(n) into a time domain, analog signal z(t).

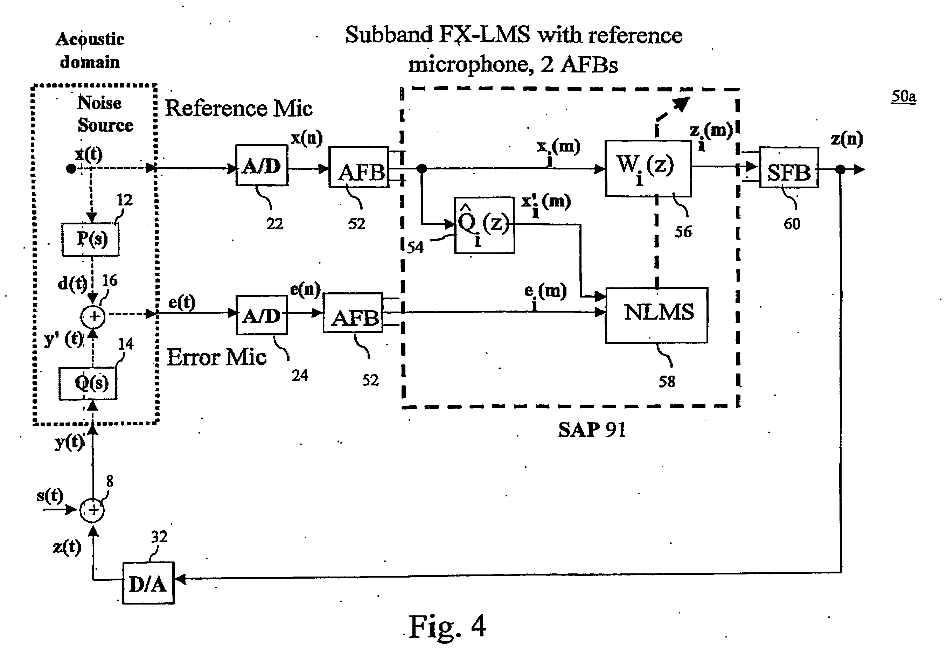

Figure 4 illustrates a subband ANC system 50a for two microphones. In Figure 4, adaptive processing is implemented in a SAP block 91. The system 50a of Figure 4 employs suband FX-LMS, and includes a block 54 that includes a subband estimate of Q(s) depicted as $\hat{Q}i(z)$,i=0,1,..., K-1. Subband estimation and implementation of Q(s) allows for faster computation due to parallel subband processing by filters $\hat{Q}i(z)$. This allows the system 50a to include only two AFBs 52 for two microphones. One AFB is provided to x(n), while the other is provided to e(n). K (possibly complex) subband adaptive filers (SAFs) Wi(z) 56 (Wi(z), i=0,1,..., K-1) generate subband output signals zi(m), i=0,1,...,K-1, based on xi(m), i=0,1,..., K-1. A block (such as NLMS) 58 is provided to adapt the subband adaptive filters Wi(z), A SFB 60 combines the subband output signals zi(m), i=0,1,...,K-1, to obtain the time domain signal z(n), The D/A converter 32 converts the time domain, digital signal z(n) into a time domain, analog signal z(t).

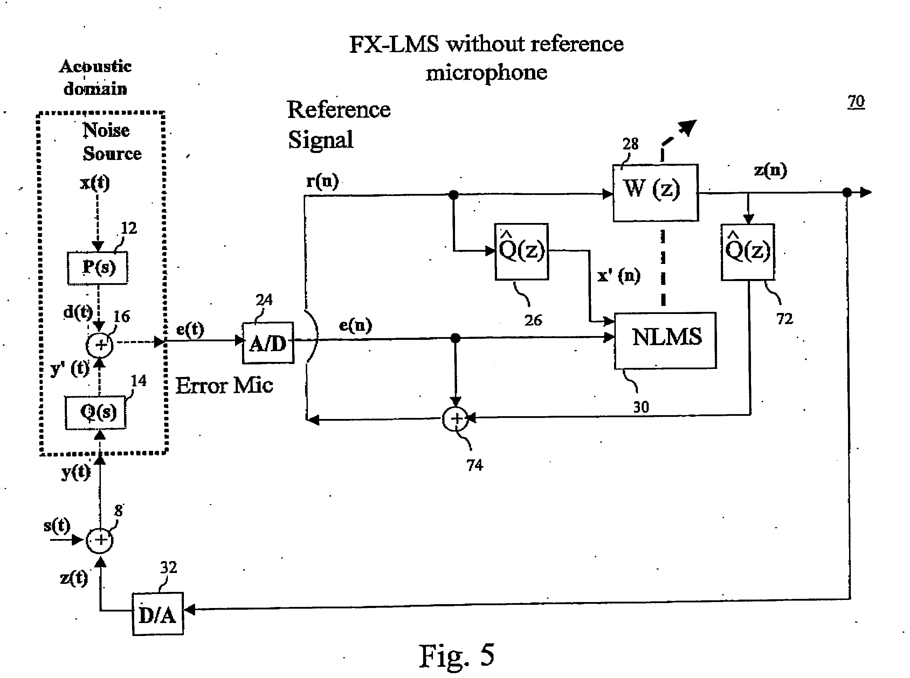

It is possible to implement FX-LMS with only one microphone as illustrated in Figure 5. Figure 5 shows a conventional feedback ANC system 70. The system 70 is disclosed in Kuo-Morgan99. In Figure 5, the reference signal is reconstructed in the system (signal r(n)) via a discrete-time estimated transfer function $\hat{Q}(z)$ 72 and a summation node 74,

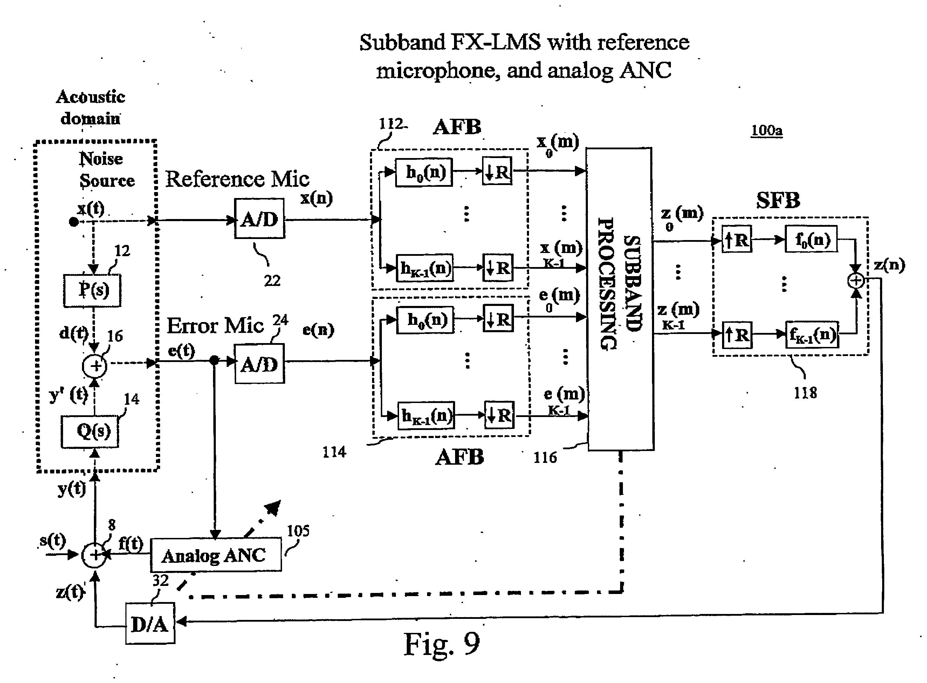

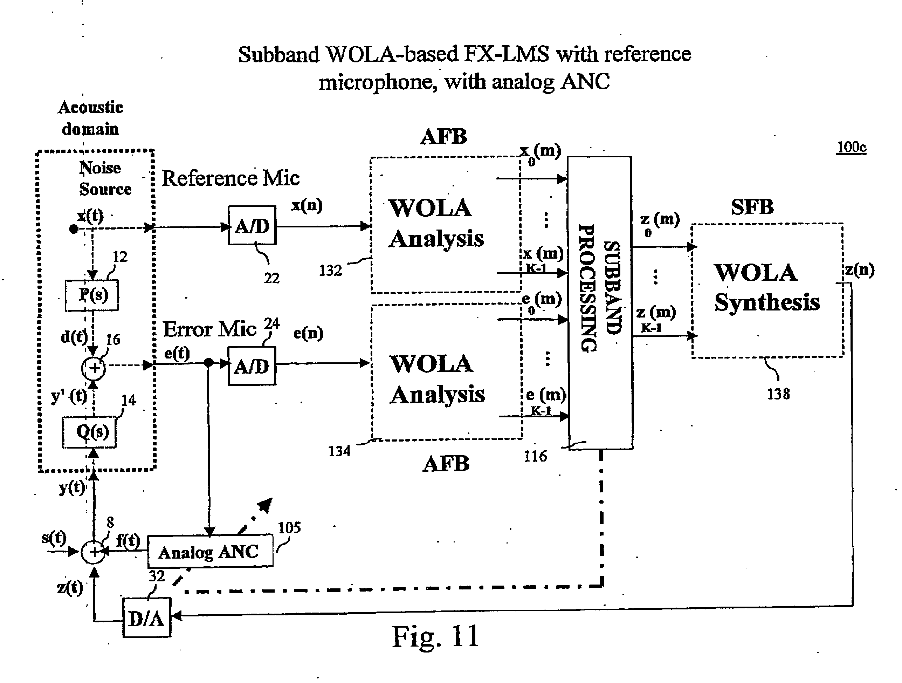

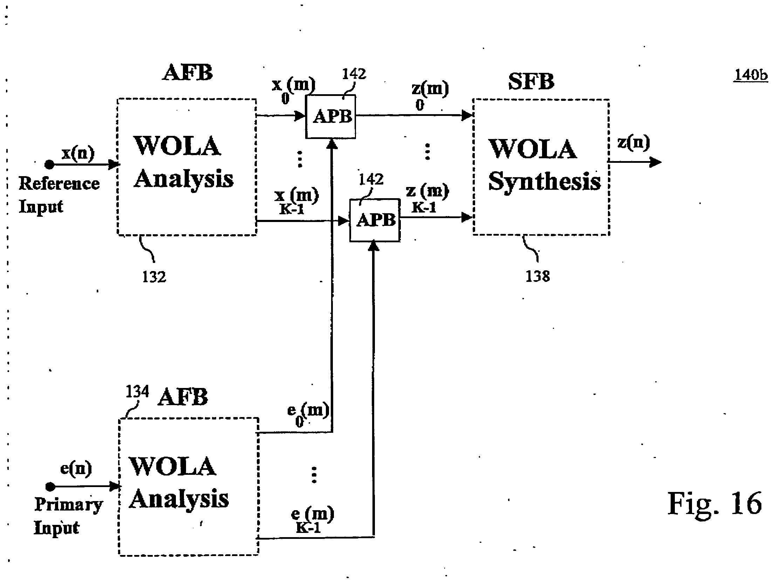

The system 50a of Figure 4 may be implemented using oversampled filterbank as shown in Figure 9, AFBs 52 of Figure 4 may be implemented by over-sampled analysis filterbanks 112,114 of Figure 9, WOLA implementation offers a low-delay, flexible, and efficient implementation of the over-sampled filterbanks as described in U.S. Patent Nos. 6,236,731, 6,240,192 and 6,115,478, which are incorporated herein by reference. The system 50a of Figure 4 may be implemented using WOLA filterbank as shown in Figures 11 and 16. AFBs 52 of Figure 4 may be implemented by WOLA analysis filterbanks 132, 134 of Figures 11 and 16, and SFB 60 of Figure 4 may be implemented by a WOLA synthesis filterbank 13 8 of Figures 11 and 16.

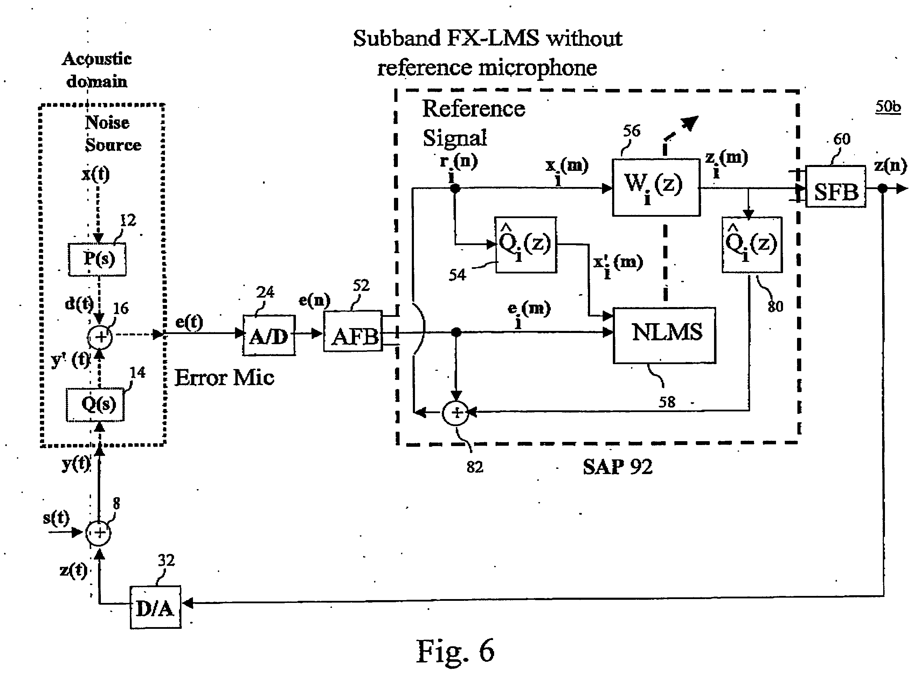

Figure 6 illustrates a subband feedback ANC system 50b. A subband implementation of feedback FX-LMS system is shown in Figure 6. In Figure 6, adaptive processing is implemented in a SAP block 92. The reference signal is reconstructed in the system 50b via $\hat{Q}i(z)$, i=0,1,..., K-1 (referenced by 80) and a summation node 82. The block 80 includes a subband estimate of Q(s) depicted as $\hat{Q}i(z)$, i=0,1,..., K-1.

As discussed in the prior art (Kuo-Morgan99), the use of AFBs in subband implementations may impose delays on the signal that are often prohibitively large for the operation of the system.

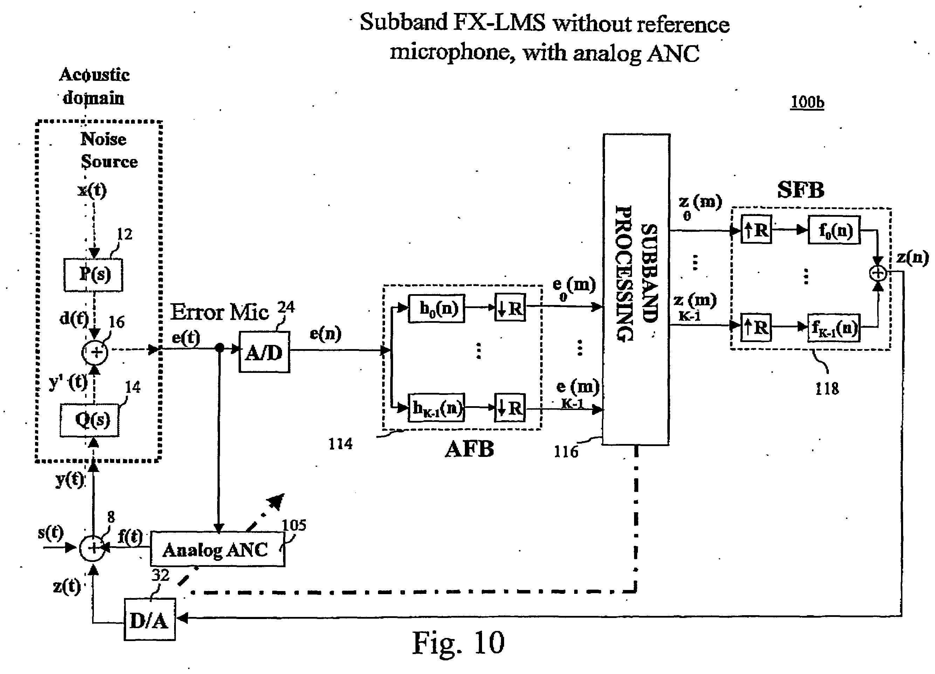

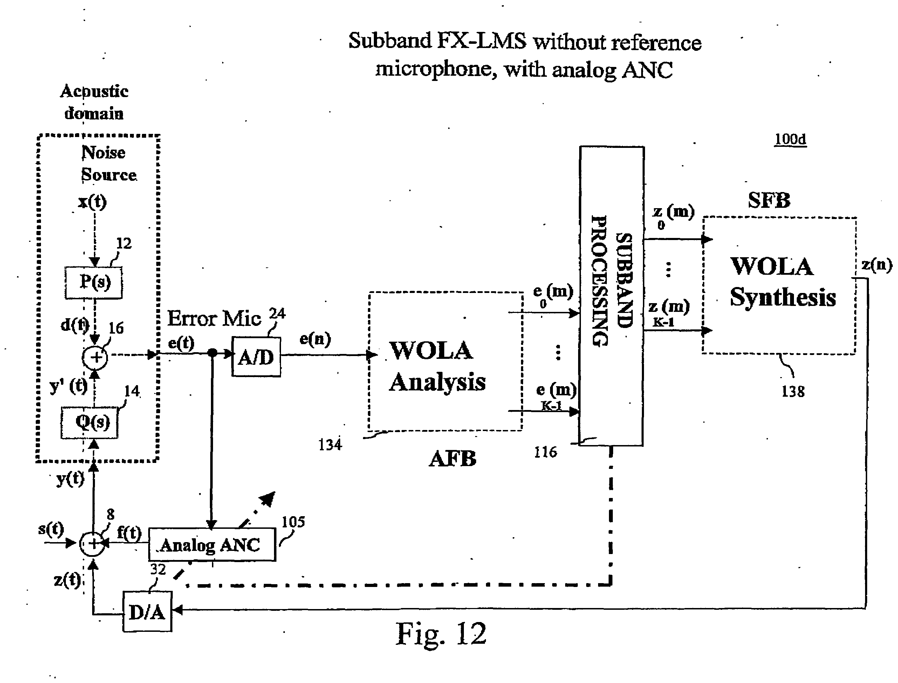

The system 50b of Figure 6 may be implemented using oversampled filterbank as shown in Figure 10. AFB 52 of Figure 6 may be implemented by an over-sampled analysis filterbank 114 of Figure 10. The system 50b of Figure 6 may be implemented using WOLA filterbank as shown in Figure 12, AFB 52 of Figure 6 may be implemented by a WOLA analysis filterbank 134 of Figure 12, and SFB 60 of Figure 6 may be implemented by a WOLA synthesis filterbank 138 of Figure 12,

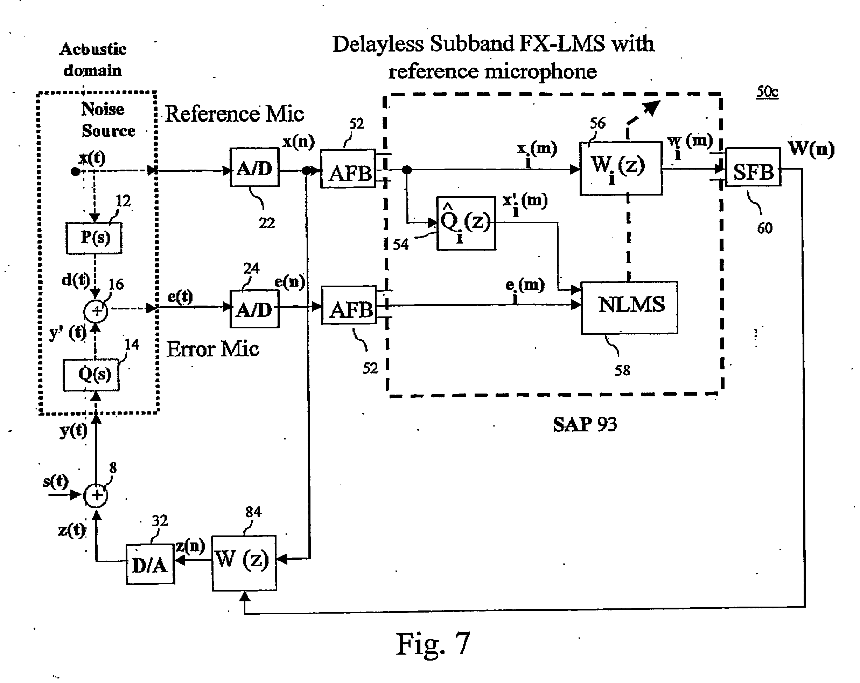

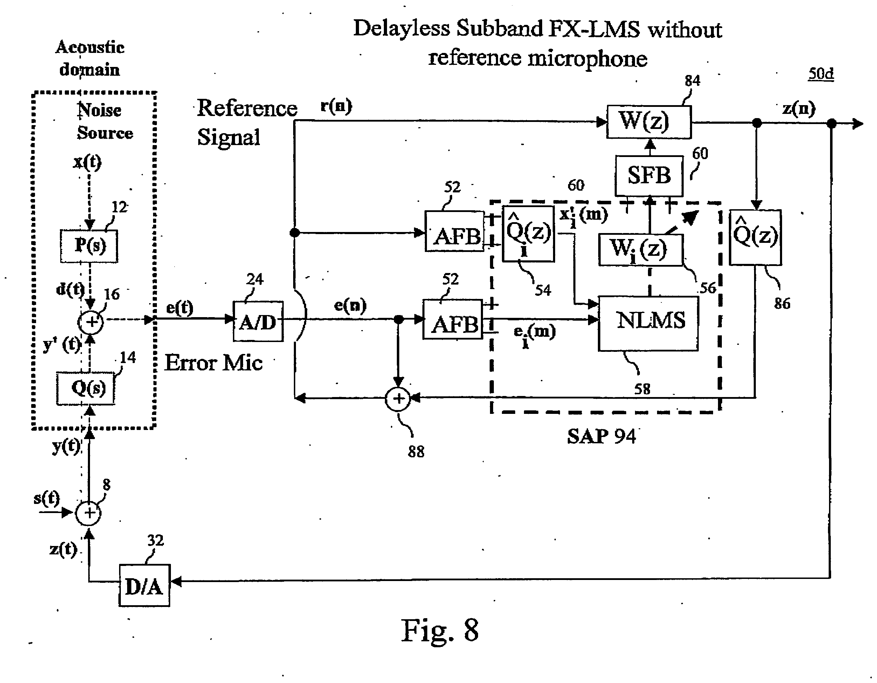

Delayless subband ANC systems associated with the systems of Figures 4 and 6 are shown in Figures 7 and 8. Figure 7 illustrates a delayless feed-forward subband ANC system 50c. Figure 8 illustrates a delayless subband feedback ANC system 50d. In Figure 7, adaptive processing is implemented in a SAP block 93, In Figure 8, adaptive processing is implemented in a SAP block 94. Each of the systems 50c and 50d includes the components of the system 50a of Figure 4, and further includes a single time-domain filter W(z) 84. The time-domain filter W(z) 84 is an FIR adaptive filter synthesized from subband adaptive filters 56 by SFB 60 and applied for adaptive filtering in time-domain.

In each of Figures 7 and 8, SFB 60 is provided to convert the SAFs Wi(z), i=0,1,..., K-1 into the single time-domain filter W(z)84. Thus, delays due to AFBs are not seen in the signal path. The method to obtain the time-filter from the SAFs is disclosed below in a further embodiment(s) associated with delayless SAF. Using this method, the processing delay of the filterbank is eliminated from the adaptive processing. As a result, more non-stationary components of the noise can also be cancelled through the digital ANC part of the system.

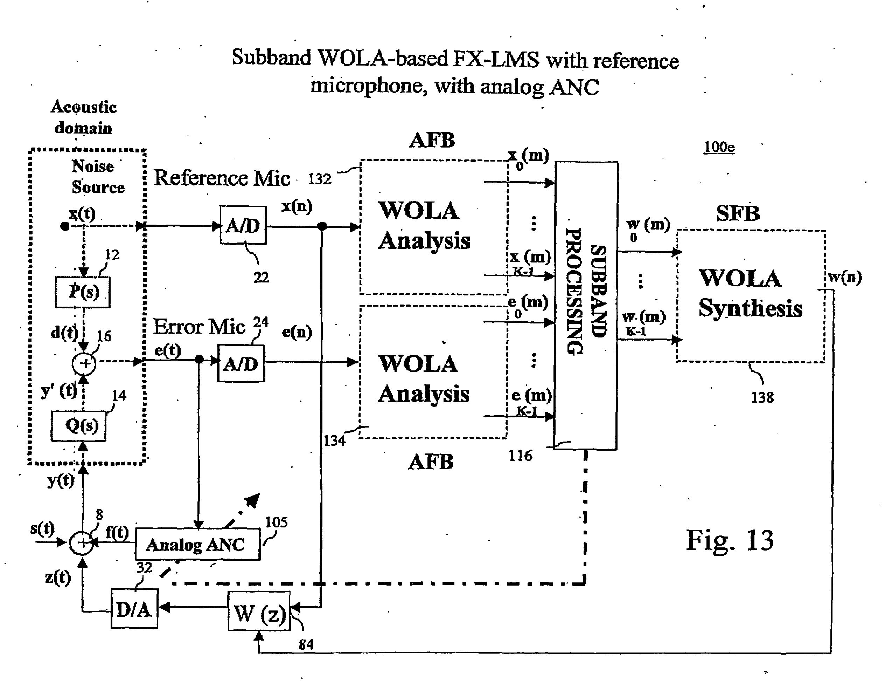

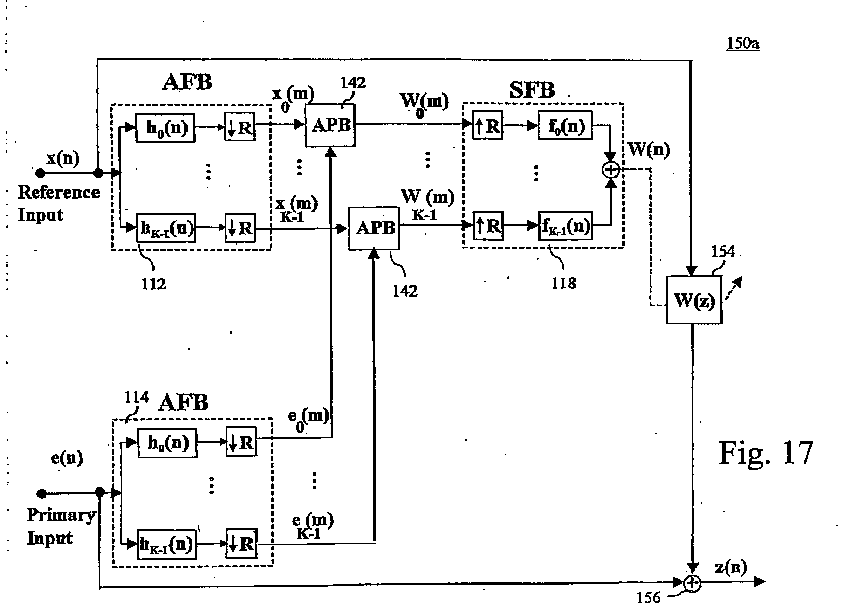

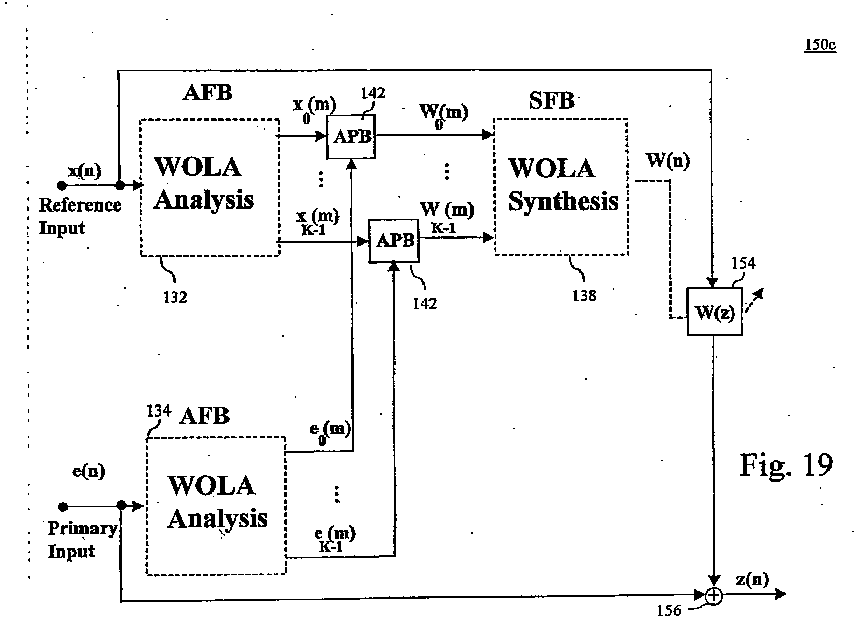

The system 50c of Figure 7 may be implemented using oversampled filterbank as shown in Figure 17. AFBs 52 of Figure 7 may be implemented by over-sampled analysis filterbanks 112, 114 of Figure 17. The system 50c of Figure 7 may be implemented using WOLA filterbank as shown in Figures 13 and 19. AFB 52 of Figure 7 may be implemented by WOLA analysis filterbanks 132,134 of Figures 13 and 19, and SFB 60 of Figure 7 may be implemented by a WOLA synthesis filterbank 138 of Figures 13 and 19,

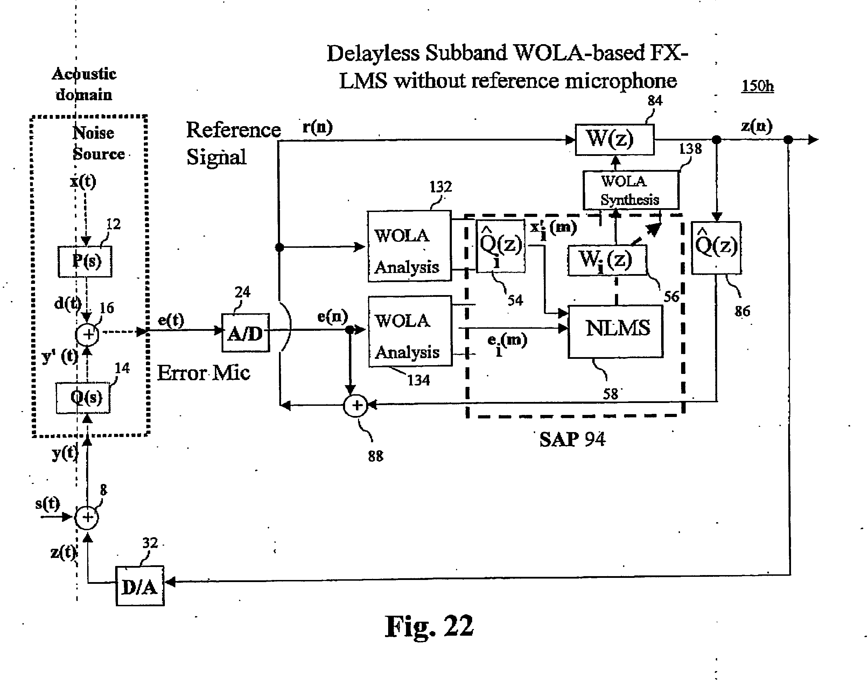

The system 50c of Figure 8 may be implemented using oversampled filterbank. The system 50c of Figure 8 may be implemented using WOLA filterbank as shown in Figure 22. AFBs 52 of Figure 8 may be implemented by WOLA analysis filterbanks 132,134 of Figure 22, and SFB 60 of Figure 8 may be implemented by a WOLA synthesis filterbank 138 of Figure 22.

U.S. Patent Application Publication No. 20030198357 (Serial No. 10/214,056), entitled "Sound Intelligibility Enhancement Using a Psychoacoustics Model and an Over-sampled Filterbank", which is incorporated herein by reference, discloses the use of ANC in combination with other techniques to improve the intelligibility of audio signals. The sound intelligibility enhancement disclosed in this U.S. application is applicable to the ANC systems of Figures 3, 4 and 6-8.

Convergence improvement techniques such as whitening by decimation (WBD), whitening by spectral emphasis (WBS), and whitening by decimation and spectral emphasis (WBDS), disclosed in U.S. Patent Application Publication Nos. 20030108214 and 20040071284 (Serial Nos. 10/214,057 and 10/642,847), which are incorporated herein by reference, can be employed in combination with all methods and systems described in Figures 3, 4, and 6-8.

A combination of an analog ANC and subband processing is now described in detail. In Figures 9-13, the analog ANC and the subband processing are combined to achieve a higher performance as described below.

Figure 9 illustrates an ANC system 100a in accordance with the present invention. The system 100a of Figure 9 includes an analog ANC 105 and subband processing. The analog ANC 105 may be the analog ANC 2 of Figure 1.

Comparing Figure 9 with Figure 1 (b), it can be seen that the analog ANC system is entirely embedded in the system 100a. The system 100a further includes a second (Reference) microphone that is possibly located outside of the headset earcup to sample the noise. The two microphone signals (x(t), e(t)) are converted to digital, discrete-time signals by the A/D converters 22 and 24 to obtain the signals x(n) and y(n) . The signals are next processed by two (identical) over-sampled analysis filterbanks 112 and 114. The subband processing block 116 processes the over-sampled subband signals (xi(m) and yi(m), i=0,1,...,K-1) output from the over-sampled analysis filterbanks 112 and 114, and detects various system and signal conditions including the brink of instability of the analog ANC 105. Accordingly, it can tune and adjust parameters of the analog ANC system 105 (such as loop-gain, and loop-filter bandwidth) and/or turn on or off certain features (such as feedback loop) of the system 100a. The outputs of the subband processing block 116 are synthesized by an over-sampled synthesis filterbank 118, which produces the time domain, digital signal z(n).

The embodiments of the present invention may also employ over-sampled subband processing to provide improved cancellation of periodic or other quasi-stationary signals. Here, the ambient noise (measured by a reference where a microphone is possibly outside the earcup for a feedforward system) is analyzed using subband techniques to determine if there are any stationary (ideally periodic) or quasi-stationary components in the ambient noise. If these components are detected, the DSP will generate a delayed version of this stationary or quasi-stationary signal (shown as z(n) in digital form and z(t) in analog) in Figure 9 and supply it to the analog ANC subsystem (105) for subtraction.

Adaptive techniques, such as subband adaptive filters on over-sampled filterbanks (OS-SAFs) similar to those disclosed in U.S, Patent Application Publication Nos. 20040071284 and 20030108214 can be employed. The FX-LMS algorithm may be employed in subband methods described in Figures 3, 4, and 6-8, where OS-SAFs and SAPs are employed. This method of combining the analog and digital ANC provides improved noise cancellation compared to a system that does not employ this technique.

It is noted that in Figure 9, the reference microphone could have dual usages: 1) to provide information to the subband processing block about the ambient noise in order to control the parameters of the analog ANC system, 2) to provide a reference signal for digital ANC part of the system (employing algorithms such as the FX-LMS). In the system 100a of Figure 9, various versions of the subband FX-LMS, such as feed-forward, feedback, and a combination of the two, may be used for the digital ANC part of the system.

In some systems, only one microphone is available (such as feedback ANC). The system 100a of Figure 9 can be modified to obtain another embodiment disclosed in Figure 10. Figure 10 illustrates a feedback ANC system 100b in accordance with a further embodiment of the present invention. In the system 100b, the subband signals for controlling the analog ANC system 105 are provided only by the error microphone. The SAP block 92 of Figure 6 can be employed as a part of the subband processing block 116 of Figure 10 to do adaptive processing. Similarly, the SAP block 91 of Figure 4 can be employed in the subband processing block 116 of Figure 9,

The over-sampled filterbanks may be efficiently implemented using WOLA analysis and synthesis. Figure 11 illustrates an ANC system 100c in accordance with a further embodiment of the present invention. The system 100c of Figure 11 includes WOLA analysis filterbanks 132 and 134 and a WOLA synthesis filterbank 138. Efficient hardware realizations of the WOLA have been disclosed in U.S. Patent Nos. 6,236,731 and 6,240,192.

The embodiments of Figures 7 and 10 may be efficiently implemented using the WOLA filterbanks as shown in Figures 12 and 13, respectively. Figure 12 illustrates a feedback ANC system 100d in accordance with a further embodiment of the present invention. Figure 13 illustrates an ANC system 100e in accordance with a further embodiment of the present invention. The subband processing block 116 of Figure 12 may employ feed-forward FX-LMS strategies, such as the SAP block 94 of Figure 8. The subband processing block 116 of Figure 13 may employ feed-forward FX-LMS strategies such the SAP block 93 of Figure 7.

The subband processing block 116 of Figures 9-13 may model one or more than one acoustic transfer function, a transfer function for a microphone, a transfer function for a loudspeaker, or combinations thereof in accordance with an application,

Monitoring the amplitude to the noise to be cancelled may save the battery life. The over-sampled filterbank can also perform this monitoring more accurately using subband processing, since more accurate decision making is possible by monitoring energies of the signals in various subbands. For example, different energy thresholds may be employed for different subbands according to the effectiveness of ANC in various frequency bands.

Delayless SAP through over-sampled synthesis/WOLA synthesis is now described in detail.

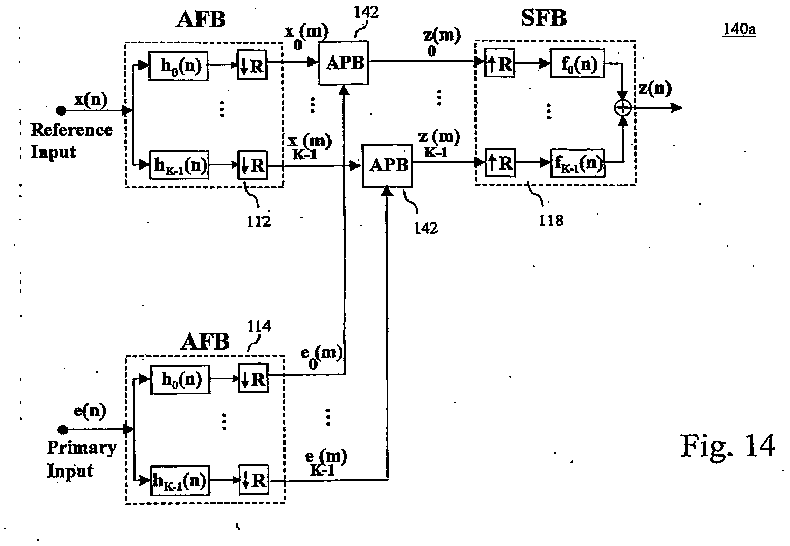

Figure 14 illustrates a conventional OS-SAF system 140a. The OS-SAF system 140a includes the over-sampled analysis filterbanks 112 and 114, subband adaptive processing blocks (APBs) 142, and the over-sampled synthesis filterbank 118, The OS-SAF system 140a has two inputs, i.e., a primary input e(n) (e.g., the error microphone signal in the ANC systems of Figures 2-5), and a reference input x(n) (e.g., the reference signal in the ANC systems of Figures 2-5). The reference inputs leaks into the primary input for example by going through an acoustic plant P(s) in Figures 2-5, As a result, the primary and reference inputs become correlated. The OS-SAF system 140a tries to eliminate the portion of the primary input that is correlated with the reference input through adaptive filtering.

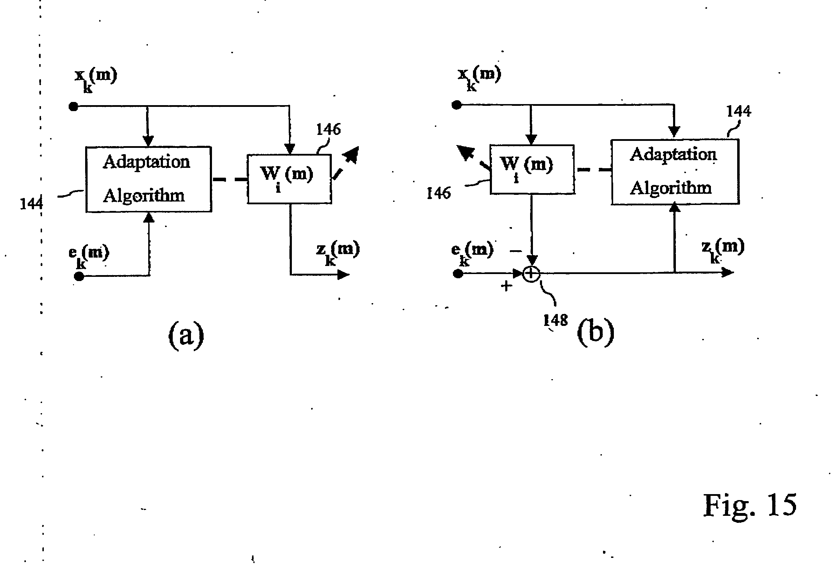

Figures 15(a)-15(b) illustrate examples of adaptive processing. The APBs of Figures 15(a)-15(b) are applicable to APB 142 of Figure 14. The APB of Figure 15(b) contains a summation node 148, while the APB of Figure 15(a) lacks the summation node 148.

The APB of Figure 15(a) is applicable to the ANC applications, such as the FX-LMS method of Figures 2-6. The summation node 146 is rather transferred to the acoustic domain as shown in the ANC systems of Figures 2-6. The APB of Figure 15(b) is applicable to applications, such adaptive interference (echo or noise) cancellation. Here the interference signal is cancelled in the digital domain through the adaptive algorithms 144, Both of the two APBs in Figures 15(a)-(b) could be equally used in the embodiment of the present invention disclosed here. For brevity, it is assumed that in the description below, the APB 142 has the form of Figure 15(b), unless otherwise stated.

An example of the disclosed time-filter reconstruction through WOLA synthesis is described for an echo cancellation application as follows.

As disclosed in U.S. Patent Application Publication Nos. 20030108214 and No. 20040071284 (Serial Nos. 10/214,057 and 10/642,847), which are incorporated herein by reference, the over-sampled analysis and synthesis filterbank operations can be efficiently implemented using the WOLA analysis and synthesis, respectively, WOLA analysis/synthesis for oversampled filterbank analysis/synthesis is disclosed in U.S. Patent Nos. 6,236,731 and 6,240,192, which are incorporated herein by reference. Figure 16 illustrates an OS-SAF system 140b having WOLA analysis filterbanks 132 and 134 and a WOLA synthesis filterbank 138.

Figure 17 illustrates an OS-SAF system 150a. In the system 150a, the subband adaptive filters Wk(n) are combined together through the filterbank synthesis process to obtain a time-domain adaptive filter W(z) 154 of W(n). The adaptive filter W(z) 154 receives the reference input x(n). The output of the adaptive filter W(z) 154 and the reference input e(n) are summed at 156.

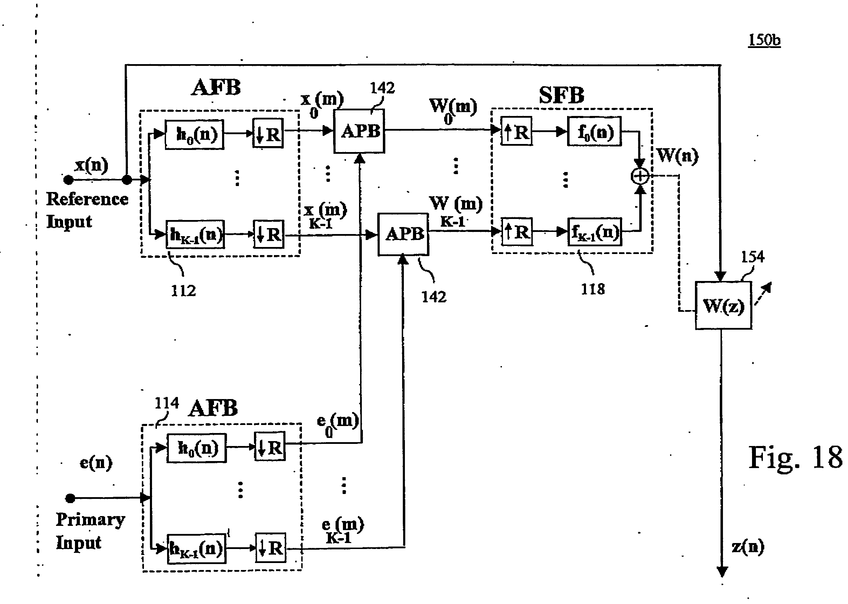

Figure 18 illustrates an OS-SAF system 150b. In the AFBs 142 of the system 150b, the AFB of Figure 15(b) is employed.

Figure 19 illustrates an OS-SAF system 150c. The system 150c corresponds to the system 150a of Figure 17, and utilizes the WOLA filterbank. As illustrated in Figure 19, the WOLA synthesis could be used to efficiently synthesize the time-domain adaptive filter. The WOLA synthesis process includes steps disclosed in U.S. Patent Nos. 6,236,731, 6,240,192 and 6,115,478.

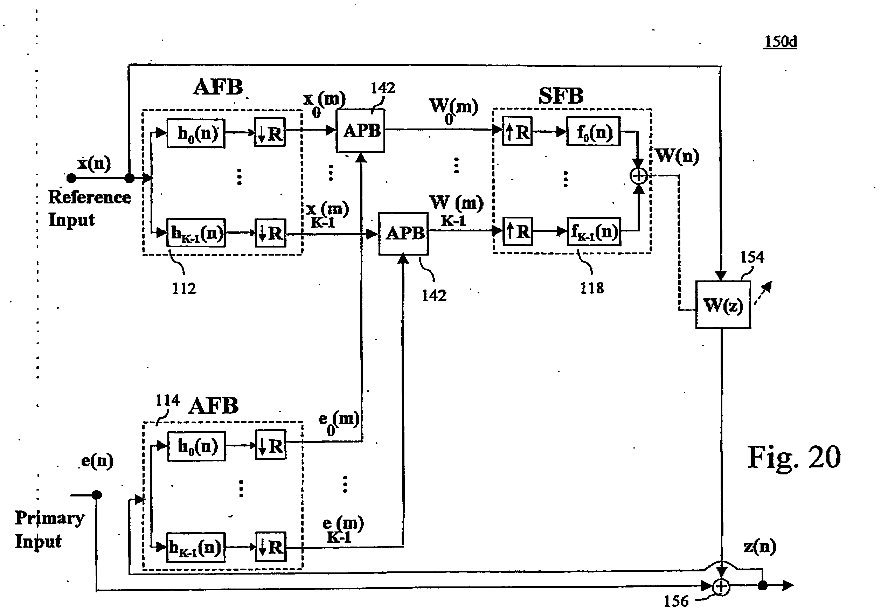

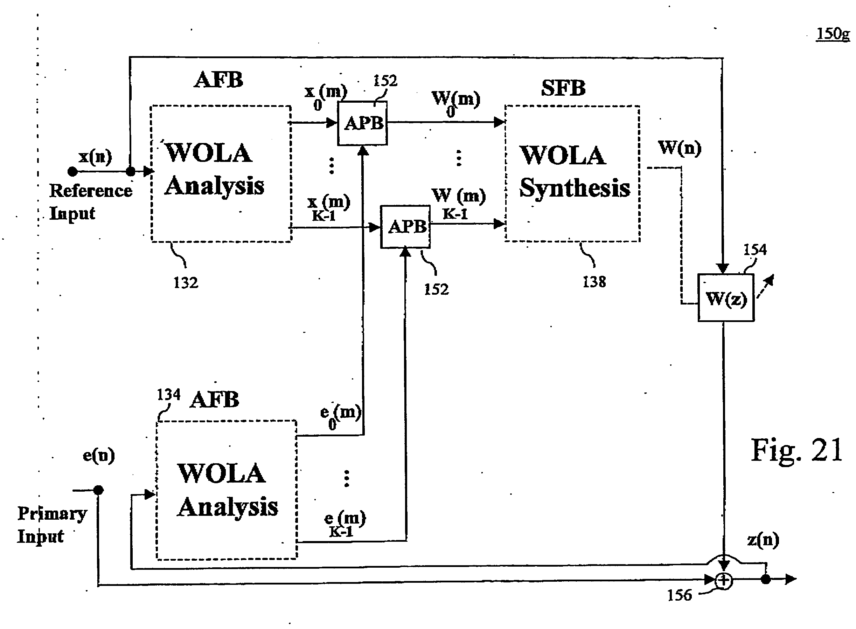

Closed-loop versions af the OS-SAF systems disclosed above are also possible. Figure 20 illustrates a closed-loop version of the system 150a in Figure 17, and Figure 21 discloses a closed-loop version of the system 150c in Figure 19. The feedback systems 150d and 150e of Figures 20-21 offer steady-state performance, since the final error signal is sensed back by the system and optimally eliminated.

Figure 22 illustrates a delayless WOLA-based subband feedback ANC system using a FX-LMS. The system 150h of Figure 22 corresponds to the system 50d of Figure 8, and utilizes the WOLA filterbank.

A. Filter reconstruction for Low-resource delayless subband adaptive filter using WOLA

Method and system for reconstruction of a time-domain adaptive filter (TAF) by using WOLA synthesis method (implemented with an oversampled filterbank) is described in detail. An inverse fast Fourier transform (IFFT) of length K is employed in the method. Due to the nature of the WOLA synthesis, the reconstruction process is distributed in time rendering it suitable for real-time implementation. The method is arranged such that segments of the TAF may be used as they become available in time. This makes the method a perfect match for sequential partial update algorithms (described later) that are often integral parts of low-resource implementations. The WOLA synthesis of the subband filters described below is efficiently implemented on an oversampled filterbank that also benefits from the WOLA implementation for its analysis stage. The system is designed and described for an echo cancellation set up thongh it could be used for other adaptive applications such active noise cancellation or adaptive feedback cancellation,

A-1. WOLA Synthesis for Filter Reconstruction

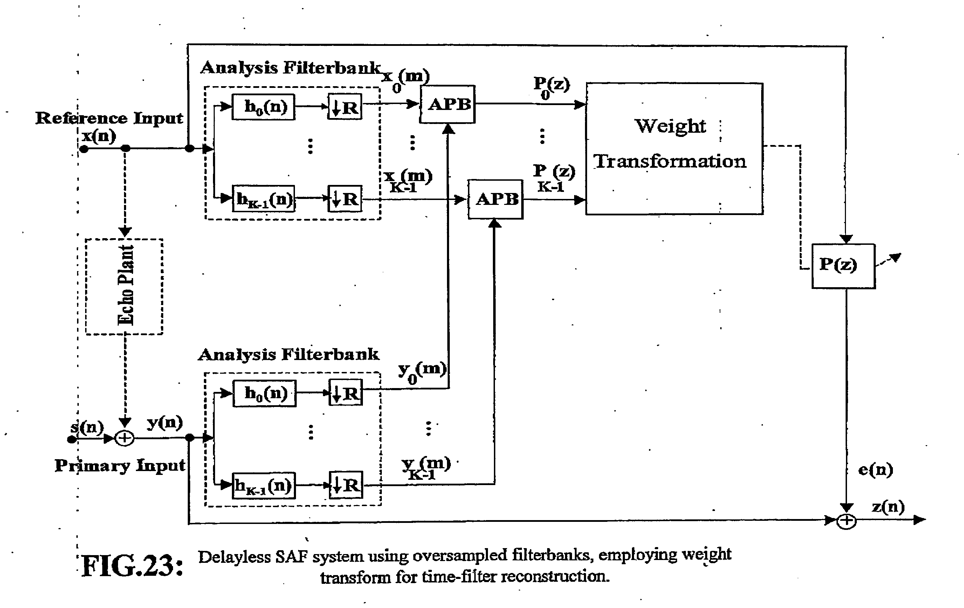

Figure 23 illustrates a delayless SAF structure with echo plant. At the output of APBs of Figure 23, the sub-band adaptive filters $P_k(z)$. $k=0,1,\cdots,K\text{-}1$ are obtained. Rather than reconstructing the output signal as in typical SAF systems, the adaptive filters are passed to a weight transformation stage to obtain the time-domain adaptive filter $P(z)$ to be used to filter the reference signal $x(n)$ in the time-domain. Assuming a synthesis filter set, in the DFT-FIR approach the TAF is obtained by passing the SAFs through a synthesis filterbank as described by the J. Huo reference and the L. Larson reference:

$$P(z) = \sum_{k=0}^{K-1} F_k(z) P_k(z^R) z^{Ls/2}$$

where R is the filterbank decimation factor, and $F_0(z)$ is the prototype filter of the filterbank, bandlimited to $\pi/R$. Synthesis filters are obtained through discrete Fourier transform (DFT) modulation of the prototype filter as $F_k(z)=F_0(zW^k)$ where $W = e^{-j2\pi/K}$. The term $z^{Ls/Z}$ is added to compensate for delay of the synthesis filter of length $Ls$.

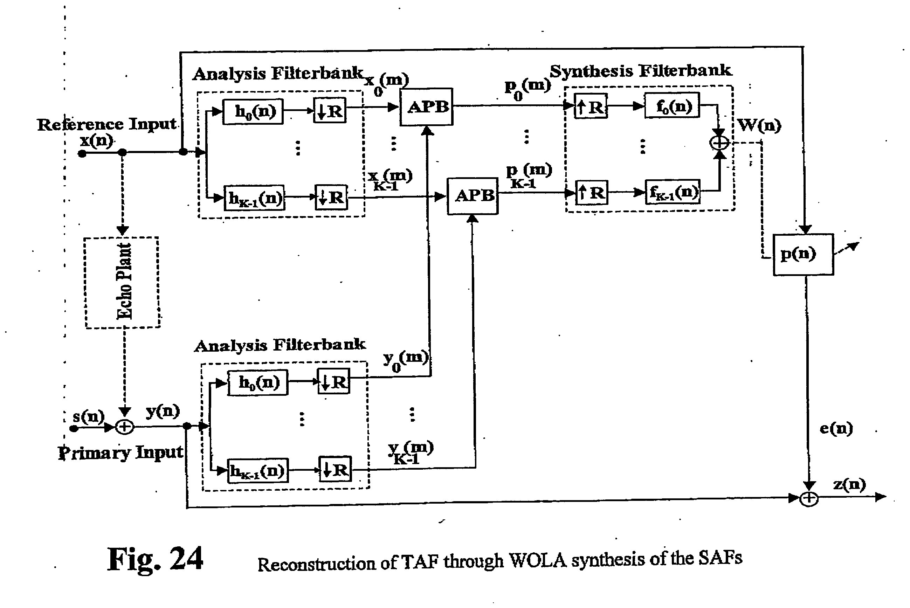

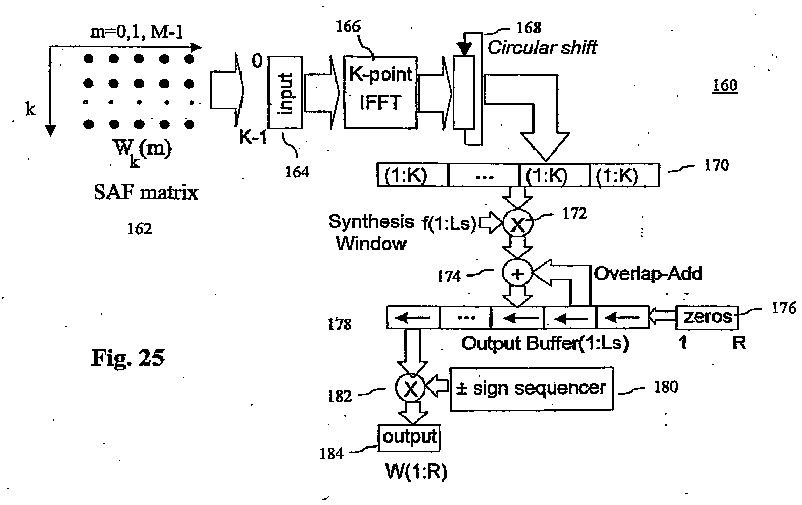

The DFT-FIR uses a polyphase-FFT structure to reconstruct the TAF through a weight transform of the SAF set. By contrast in this section, a different approach is described whereby the TAF is reconstructed through a WOLA synthesis of the SAFs. This method is more amenable to a block processing approach and more compatible to hardware implementation, Basically, this method treats the SAFs $p_k(m)$, $k=0,1,\cdots,K\text{-}1$, $m=0,1,\cdots,M\text{-}1$ as a set of $K$ subband signals, and passes them through an oversampled filterbank synthesis stage as shown in Figure 24. To efficiently implement the oversampled synthesis stage, we use the WOLA implementation as depicted in Figure 25. For further explanation, consider the SAFs all included in an SAF matrix $P$, with elements defined as $P(k,m)=p_k(m)$, $m=0,1,\cdots,M\text{-}1$, $k=0,1,\cdots,K\text{-}1$. The matrix is set as input to the synthesis stage, one column at every subband time-tick. We call this method of TAF reconstruction "sequential synthesis". As depicted in Figure 25, the WOLA synthesis starts with taking an IFFT of each column (of length *K*) of the SAF matrix. After the IFFT 166, and proper circular shifting 168, the vectors of length *K* are periodically extended to obtain a vector as long as the synthesis window. Next this result is multiplied by the synthesis window followed by an overlap-add operation. Both evenly-stacked FFT and oddly-stacked FFTs may be used. Odd stacking requires an extra sign sequencer to be employed at the final stage. The WOLA synthesis is well described in U.S. Patent Nos. 6,236,731, 6,240,192 and 6,115,478. Assuming aliasing is low in the analysis stage, the SAFs can be shown to converge to the Wiener solution. As a result, the solution will be almost independent of the analysis filter design. Thus the synthesis filter set $F_k(z)$, $k= 0,1,\cdots,K-1$ is designed independently of the analysis filter set to constitute a near perfect-reconstruction set. To obtain the TAF, the output buffer 168 in Figure 25 is first zeroed out. After reading in the input SAF matrix (one column per subband clock tick), the first *Ls*/2 samples of the output are discarded. The next *L* output samples produced a block at a time (*R* time-samples) constitute the TAF. Thus it takes *L/R* input (subband) clock ticks to obtain the TAF. Through optimized implementation it became possible to avoid the initial *Ls*/2 sample delays between consecutive filter reconstructions. The total input-output delay for the TAF filter reconstruction is thus (*La+Ls*)/2 samples where *La* denotes the analysis window length. This delay is not seen in the signal path; rather the optimal filter for the reference and primary signals is delayed by this amount. When the echo plant varies slowly (relative to this reconstruction delay), this delay does not degrade the system performance. It is possible to minimize the delay by choosing shorter analysis and synthesis windows as long as distortions in the time-filter due to the reconstruction process are kept within a tolerable range.

In the conventional SAF systems shorter analysis/synthesis windows will lead to increased output signal degradation since all signals pass through the complete filterbank as described in H. Sheikhzadeh et al. ("Performance Limitations of a New Subband Adaptive System for Noise and Echo Reduction", Proc. Of IEEE ICECS, 2003). By contrast, in the delayless SAF system of Figure 24, signals are passed through the analysis filterbank only to obtain the adaptive filter. As a result, the adverse effects of shorter analysis/synthesis windows on output signal quality is much less pronounced. It is also possible to further reduce the TAF reconstruction delay to only *La*/2 samples if one is ready to perform filterbank reconstruction of the whole SAF matrix P for every output block. We call this method of TAF reconstruction "batch synthesis" as opposed to the "sequential synthesis" described in this section. Batch synthesis will increase the computation cost from a single WOLA synthesis (per output block) in the sequential synthesis to *M* WOLA synthesis operations. It is also possible to sequentially reconstruct more than one (but less than M) columns of matrix P at every subband time-tick if the computational resources permit.

A-2 System Evaluation

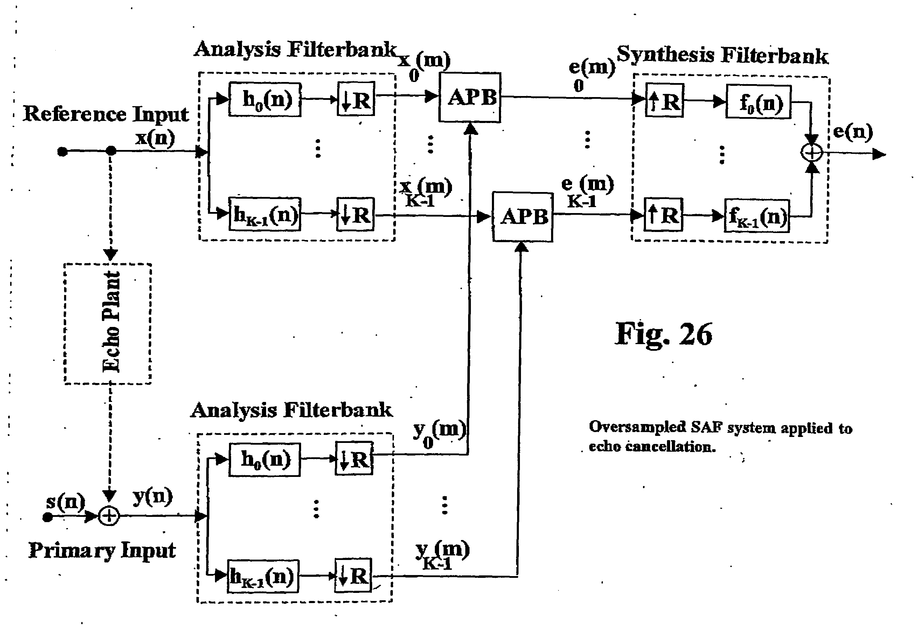

We evaluate the WOLA filter reconstruction process for a filterbank set up of: analysis and synthesis window lengths of *La = 64*, and *Ls = 128* samples with *K = 16* subbands and decimation rate of *R = 4*. The analysis filter is shorter in length (and wider in frequency domain) compared to the synthesis filter. This was chosen to provide better excitation in the analysis filter transition region leading to better convergence behavior as reported by P. L. De Leon II et al ("Experimental Results with Increased Bandwidth Analysis Filters in Oversampled, Subband Acoustic Echo Cancellers," IEEE Sig. Proc. Letters, Jan, 1995, vol. 2, pp 1-3). Each SAF $p_k(m)$ is of length *M = 32* resulting in a *16×32* SAF matrix *P*. For comparison, the same filterbank setup was also employed for the oversampled SAF system with the WOLA implementation depicted in Figure 26. The echo plant was the eighth plant of the ITUT G. 168 standard (Recommendation ITU-T G. 168, Digital Network Echo Cancellers, Int'1 Telecommunication Union, 2000), the Echo Return Loss (ERL) was *10* dB, and random white noise was used at the reference input without any near-end disturbance.

For subband adaptation, the Gauss-Seidel Pseudo-Affine Projection (GS-PAP) (Albu et al., "The Gauss-Seidel Pseudo Affine Projection Algorithm and its Application for Echo Cancellation," 37th Asilomar Conf. Sig. Sys. & Comp., Pacific Grove, Calif., Nov. 2003) with an affine order of two was employed. The method provides fast convergence and is simple enough to be targeted for a low-resource real-time implementation. GS-PAP may be superior to the Fast Affine Projection Algorithm (FAPA) since unlike the FAPA that operates on a transformed adaptive filter, the GS-PAP directly provides the adaptive filter itself (the Albu et al. reference). To demonstrate the capability of the WOLA filter reconstruction algorithm in matching sequential update algorithms, sequential update GS-PAP (SGS-PAP) described in H. Sheilchzadeh et al. ("Partial update subband implementation of complex pseudo-affine projection algorithm on oversampled filterbanks", ICASSP, 2005 IEEE International Conference on Acoustics, Speech, and Signal Processing, March 18-23, 2005, US) was also used for subband adaptation.

SGS-PAP employs sequential update of the adaptive filter in the framework of GS-PAP to reducé computation cost The sequential decimation factor of the SGS-PAP was chosen to be eight (*D = 8*). This means only one polyphase component (of length *32/8=4* taps) out of a total of *8* components of each SAF is adapted at each subband clock tick. For *D = 1*, the SGS-PAP is obviously the same as GS-PAP. In the delayless algorithm, a block of *R* new samples of the TAF is available every subband tick. This new block is used to update the TAF as soon as it becomes available. This way a smooth and continuous filter reconstruction is achieved.

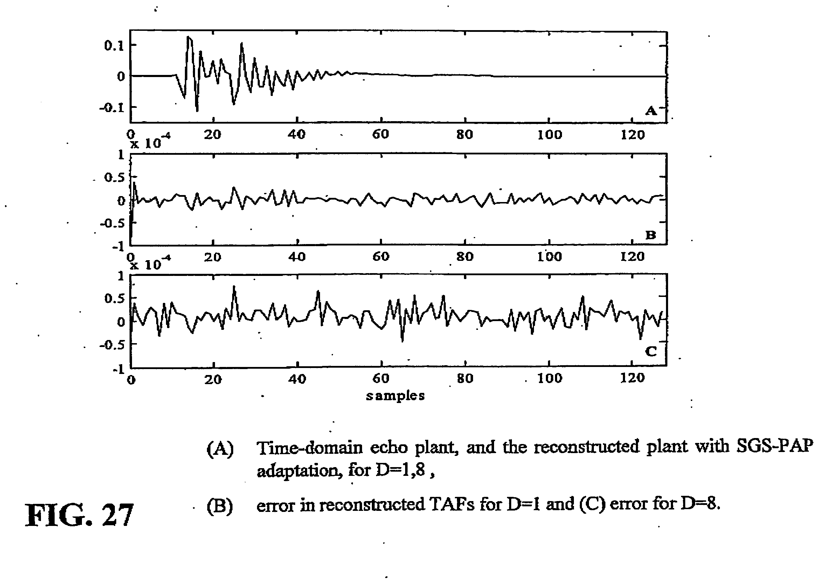

Figure 27 shows (A) Time-domain echo plant, and the reconstructed plant with SGS-PAP adaptation, for $D=1,8$, and (B) error in reconstructed TAFs for $D=1$ and (C) error for $D=8$

Figure 27 illustrates the ERLE results for the SAF system of Figure 26 as well as the delayless WOLA filter synthesis algorithm (Figures 24 and 25), employing SGS-PAP with $D = 1,8$. As expected, the delayless method achieves a greater ERLE compared to the SAF system, partially due to the fact that the input signals are not passed through the WOLA analysis/synthesis stages. This is consistent with the result and analysis presented in the J, Huo reference and the L. Larson reference. The SGS-PAP method shows a slight performance degradation for $D = 8$ (for both the SAF and the delayless methods) since the subband adaptive filters are updated at a much lower rate. Adaptation cost is, however, reduced by a factor of $D=8$.

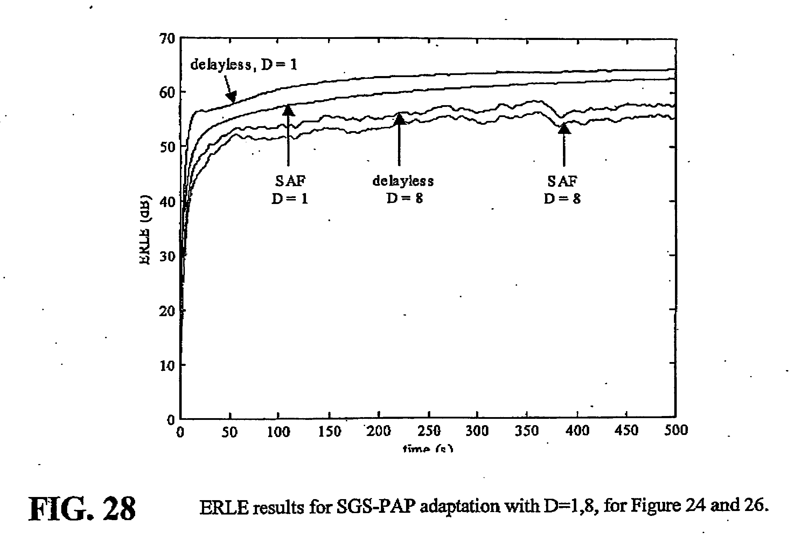

Figure 28 illustrates the ERLE results for SGS-PAP adaptation with $D = 1,8$, for the SAF system of Figure 26 and the delayless SAF algorithms of Figure 24.

Using the WOLA synthesis, the TAF was synthesized. Figure 27-A shows the synthesized time-filter for SGS-PAP adaptation with $D = 1,8$, super-imposed on the ITUT plant. As shown the three impulse responses are almost identical. To observe the differences, Figures 27-B and 27-C depict time-domain differences between each of the synthesized time-filters and the ITUT plant for $D = 1,8$. As shown, the differences are negligible in both cases, and higher for $D=8$ as predicted by the ERLE results.

The WOLA structure is more amenable with a block processing system (R.E. Crochiere et al. "Multirate digital signal processing", Prentice-Hall, NJ, 1983). As illustrated in Figure 25, for every input vector, all the processes (after the IFFT) occur sequentially to generate R samples of output. All various blocks of Figure 25 can thus operate synchronously with a single subband clock, and there is no need to extra buffering. Since the WOLA filterbank is a block processing system, every slice generated from the IFFT block that must be overlap-added to the previous results has a common exponent. This simplifies the architecture, reducing power and enhancing throughput as described in U.S. Patent Nos. 6,236,731, 6,240,192 and 6,115,478. The same does not hold for straightforward polyphase implementation of the J. Huo reference since it is a stream processing method. In the polyphase filterbank synthesis of the J. Huo reference, a separate convolution of one of polyphase synthesis filters (with one of the K subband signals) has to occur for each sample of output. To do this, $K$ different data buffers have to be updated. To summarize, the WOLA synthesis of Figure 25 provides a simpler, more modular structure for real-time hardware implementation as described in U.S. Patent Nos. 6,236,731, 6,240,192 and 6,115,478.

The method, based on WOLA synthesis of the SAFs, is efficient and is well mapped to a low-resource hardware implementation. Also the WOLA adaptive filter reconstruction may easily be spread out in time simplifying the necessary hardware. This time-spreading may be easily combined with partial update adaptive algorithms to reduce the computation cost for low-resource real-time platforms.

A-3 Filter Reconstruction and Evaluation

An example for reconstruction by WOLA is described, using WOLA setup of analysis window length of L=128, with K = 32 subband, and decimation rate of R = 8. Assume (without loss of generality) that APB's are of the form illustrated in Figure 15(b) employed for an echo cancellation application. The collection of K SAFs for subbands k = 0,1,...,K-1 is shown in Figure 25. Each SAF $W_k$ (m) is of length M,n=0,1,...,M-1 resulting in a Kby M SAF matrix. The system 150c of Figure 19 for echo cancellation is employed using the eighth plant of the ITUT G. 168 standard for echo generation. The reconstruction process of Figure 25 was applied to this simulation.

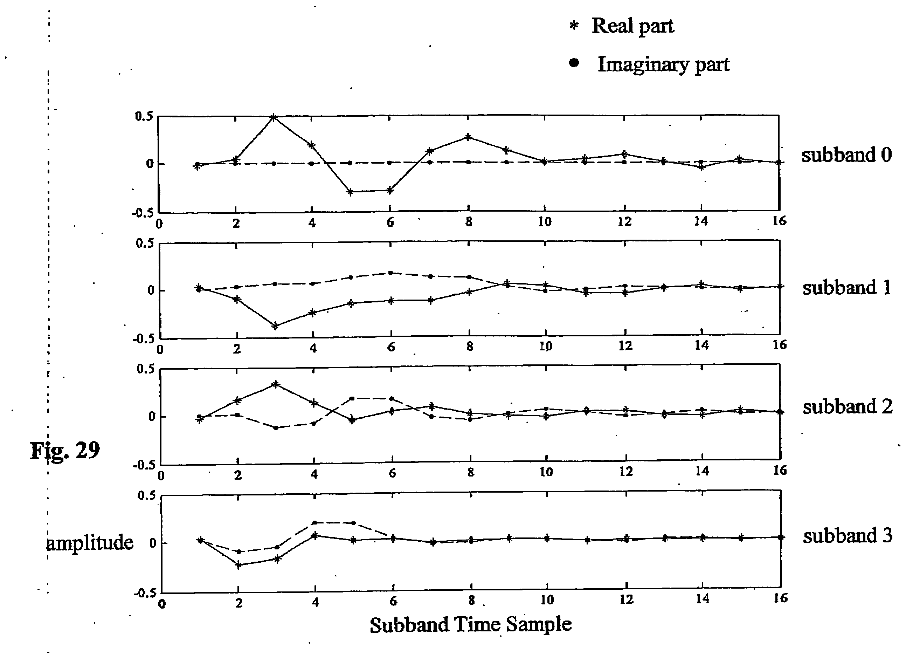

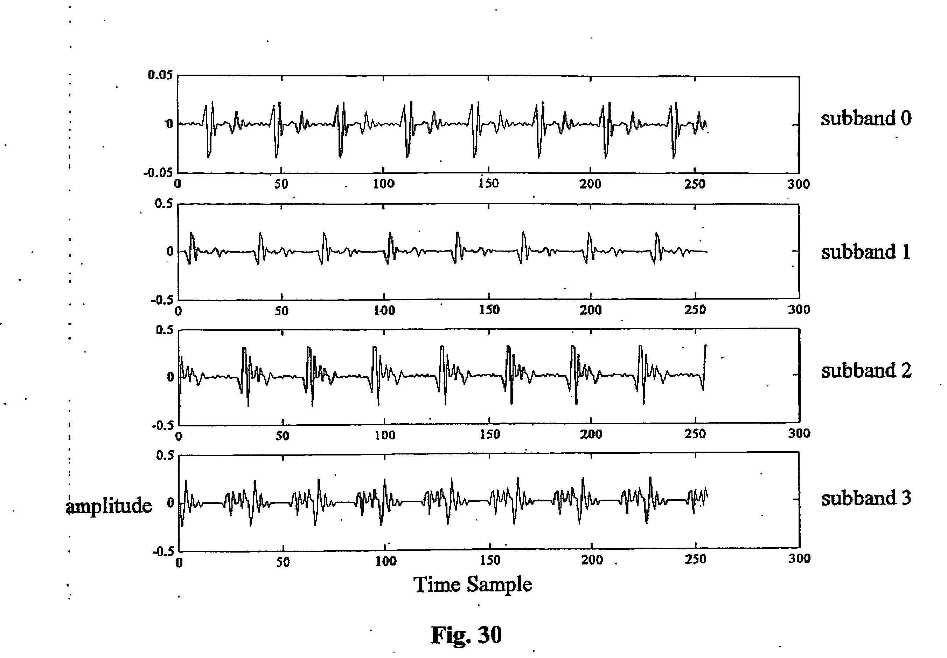

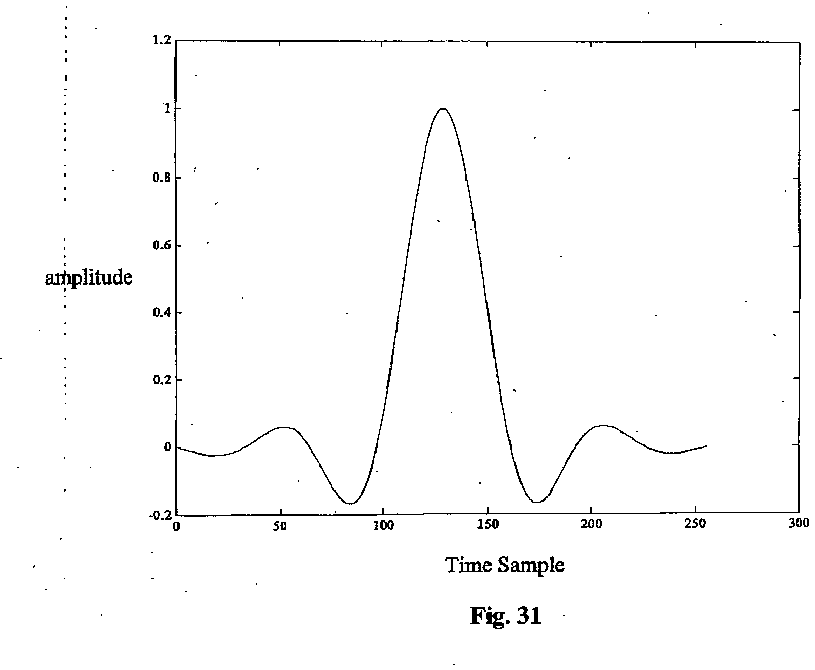

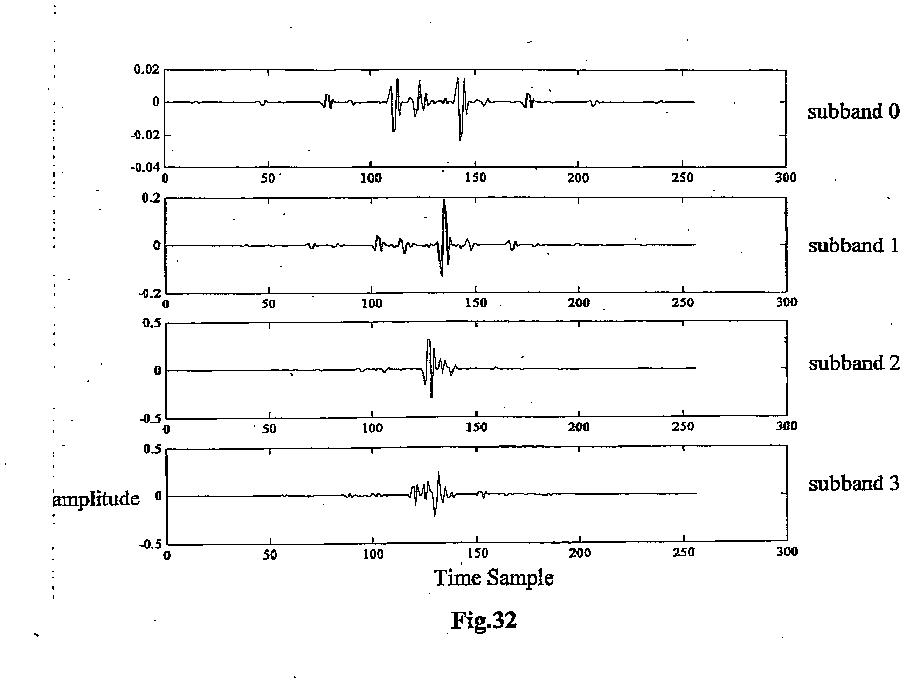

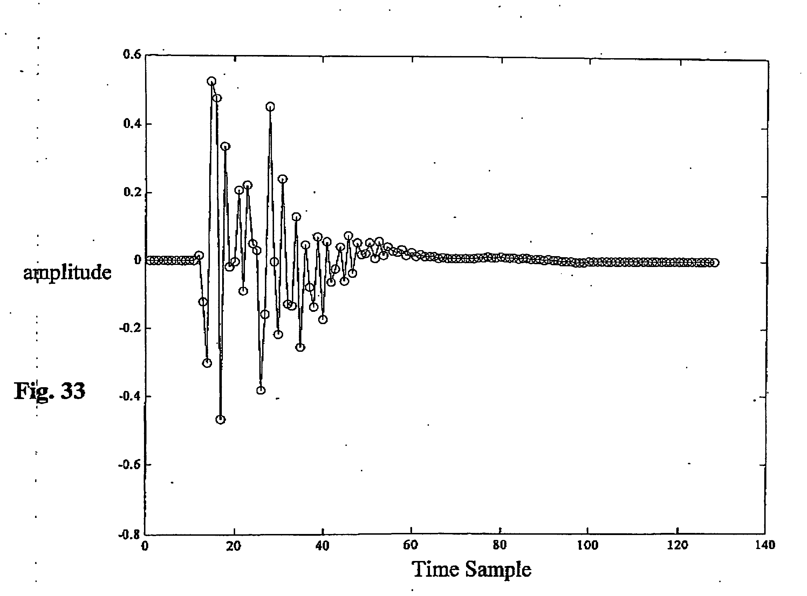

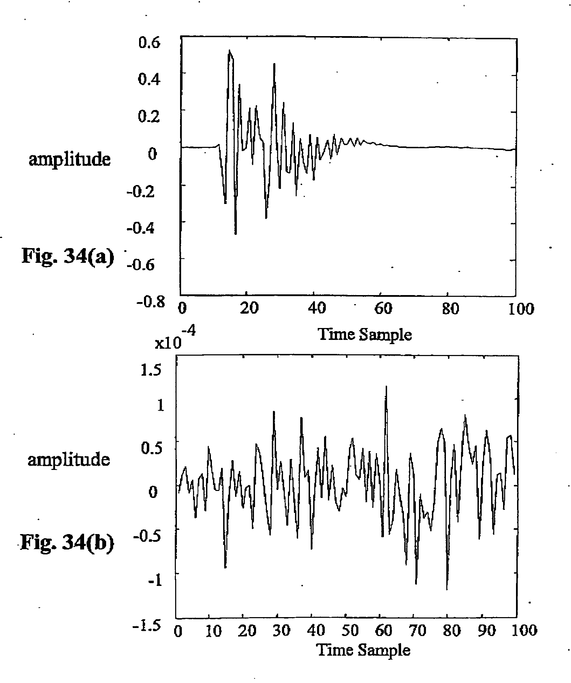

Figure 29 shows an example of real and imaginary parts of SAFs for subbands k = 0,1,2,3 for the subband adaptive system after convergence, Treating each SAF as a subband signal, the process of WOLA synthesis starts with taking the IFFT of each column (of length K) of the SAF matrix. There are M columns to be processed. After IFFT, and proper circular shifting, the vectors of length K are periodically extended to obtain vectors as long as the synthesis window. The result of periodic extension is shown in Figure 30 for the SAFs shown in Figure 29, where a total length of 256 samples (8 periodic extensions) is used. Then a synthesis window (of length Ls = 256 samples) is applied to the periodically extended signals. A typical window is shown in Figure 31 and the result of window application is shown in Figure 32. The last step is the overlap-add of the vectors (a total of M vectors involved). Using a properly designed synthesis window, the time-domain filter is synthesized in time as shown in Figure 33. Figure 34(a) shows the synthesized time-filter super-imposed on the ITUT plant As shown, the synthesized time-filter and the ITUT plant are almost identical. Figure 34(b) illustrates the time-domain difference between the synthesized time-filter and the ITUT plant. As shown, the difference is negligible.

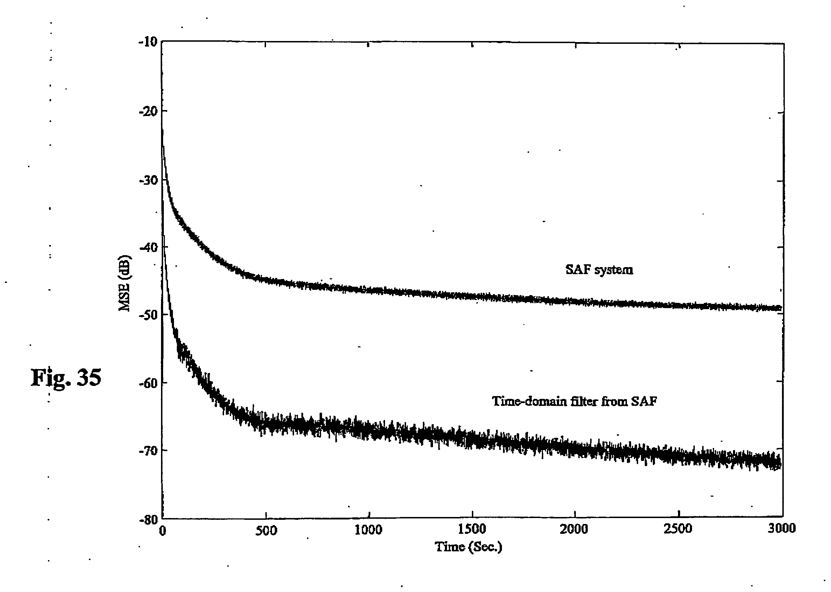

The time-domain filter can be used for adaptive filtering. As illustrated in Figure 35, for random noise input and the same ITUT plant, the echo attenuation of the time-domain filter is superior to the SAF filter using the NLMS algorithm. This is partially due to the fact that the input signal to the time-domain filter is not passed through the WOLA analysis stage (hence not experiencing distortions), as shown in Figure 4.

It is noted that as for the method of adaptation of SAFs (e.g., NLMS 30, 58), the Normalized Least Mean Square (NLMS), the Affine Projection Algorithm (APA) and its variants such as Fast APA (FAPA), or the Recursive Least Squares (RLS) may also be used.

The corresponding Canadian Patent Application No. 2,481,629 also describes reconstruction of TAF by WOLA, which is incorporated herein by reference,

The embodiments of the present invention reduces acoustic feedback and provide as high a degree of cancellation for periodic or other quasi-stationary signals.

The embodiments of the present invention automatically adapts to the different acoustic situations presented by different headsets and to the normal variations encountered in production parts.

As described above, over-sampled filterbank processing and system architecture disclosed in U.S. Patent Nos. 6,240,192 B1, 6,236,731 B1, and 6,115,478 provide low group delay, low power and small size. The embodiments of the present invention can be efficiently implemented on the system architecture disclosed in U.S. Patent Nos. 6,240,192 B1, 6,236,731 B1, and 6,115,478.

As described above, an analog ANC provides noise cancellation at predominantly low frequencies (below 1500 Hz to 2000 Hz), The embodiments of the present invention can extend this frequency range. The introduction of a DSP processor also permits additional processing to be incorporated, including techniques that can improve speech intelligibility at frequencies where even DSP enhanced analog ANC ceases to provide benefit, as described in U.S. Patent Application Publication No. 20030198357 (Serial No. 10/214,056). U.S. Patent Application Publication No. 20030198357 discloses a sound intelligibility enhancement (SIE) using a psychoacoustic model and preferably an oversampled filterbank. When combined with ANC, the SIE performs better since ANC provides more benefit at low frequencies while SIE provides more benefit at high frequencies. Using the ANC, undesired dynamic range reduction is avoidable due to low-frequency noise.

The embodiments of the present invention disclosed above prevents acoustic feedback in a manner that retains high fidelity and good performance in the presence of typical disturbances. Subband acoustic feedback reduction is employed to extend the operating frequency range by permitting more loop gain to be introduced before the onset of acoustic feedback. This type of feedback cancellation introduces fewer artifacts than full band approaches for feedback cancellation. It also provides better performance in the presence of coloured noise (disturbances). Finally the reduced group delay (compared to a full band system with similar feedback cancellation performance) provides a faster response time for feedback cancellation,

As detailed in the U.S. Patent No. 6,118,878, the brink of instability can be detected by finding the ratio of external to internal noise at high frequencies. Alternatively, the residual signal can be monitored at various frequencies to detect and prevent an impending instability. Employing an over-sampled filterbank provides more accurate and reliable prediction of impending instabilities. Generally, the overall control of the ANC system employing an over-sampled subband approach is more efficient, and accurate.

The delayless OS-SAF in accordance with the embodiments of the present invention considerably reduces the delay introduced in the primary signal path. Also, since the actual echo cancellation occurs in time-domain, inevitable distortions due to over-sampled filterbank analysis/synthesis is avoided. As the results demonstrate, the delayless SAF method proposed outperforms the traditional OS-SAFs in terms of adaptive noise and echo cancellation performance. This is possible due to avoiding errors due to band edges in the OS-SAF system.

The embodiments of the present invention provide a combination of OS-SAF and time-domain filtering. Comparing to a full band system with similar adaptive processing, this combination provides a faster convergence and response time of the adaptive system,

The embodiments of the present invention may be implemented by hardware, software or a combination of hardware and software having the above described functions. The software code, either in its entirety or a part thereof, may be stored in a computer readable medium. Further, a computer data signal representing the software code which may be embedded in a carrier wave may be transmitted via a communication network. Such a computer readable medium and, a computer data signal and carrier wave are also within the scope of the present invention, as well as the hardware, software and the combination thereof.

All citations are hereby incorporated by reference.

The present invention has been described with regard to one or more embodiments. However, it will be apparent to persons skilled in the art that a number of variations and modifications can be made without departing from the scope of the invention as defined in the claims.

## Claims

1. A system for active noise cancellation (100a-e), comprising:

   a first over-sampled analysis filterbank (114, 134), for transferring a primary signal (e(t)) in a time-domain, which is associated with an acoustic signal and may be contaminated by noise, into a plurality of subband primary signals ($e_0(m)$ - $e_{K-1}(m)$) in a frequency-domain;
   a subband processing module (116) for the subband primary signals ($e_0(m)$ - $e_{K-1}(m)$) and implementing one or more than one subband adaptive algorithm in the frequency-domain; and
   an over-sampled synthesis filterbank (118, 138) for transferring the outputs ($z_0(m)$ - $z_{K-1}(m)$) of the subband processing module (116) into a time-domain output signal (z(t)),

**characterized by**

an analog active noise cancellation (ANC) system (105) for performing an active noise cancellation to the primary signal (e(t)) in the time-domain,

the subband processing module (116) including means for implementing the adaptive algorithm for adjusting one or more than one parameter of the analog ANC system (105).

2. A system (100a-e) according to claim 1, further comprising:

a second over-sampled analysis filterbank (112, 132) for transferring a reference signal (x(t)) in the time-domain, which is associated with the noise, into a plurality of subband reference signals $(x_0(m) - x_{K-1}(m))$ in the frequency-domain; the subband processing module (116) processing the subband primary signals $(e_0(m) - e_{K-1}(m))$, the subband reference signals $(x_0(m) - x_{K-1}(m))$ or combinations thereof, and implementing the one or more than one subband adaptive algorithm in the frequency-domain.

3. A system (100a-e) as claimed in claim 1 or 2, comprising:

a second over-sampled analysis filterbank (112, 132) for transferring a reference signal (x(t)) in the time-domain into a plurality of subband reference signals $(x_0(m) - x_{K-1}(m))$ in the frequency-domain, the reference signal (x(t)) in the time-domain being associated with the noise; the subband processing module (116) processing the subband primary signals $(e_0(m) - e_{K-1}(m))$, the subband reference signals $(x_0(m) - x_{K-1}(m))$ or combinations thereof, and adjusting the one or more than one parameter of the analog ANC system (105).

4. A system (100a-e) according to claim 1, wherein the first over-sampled analysis filterbank (114, 134) includes a first WOLA analysis filterbank (134) for transferring the primary signal (e(t)) in the time-domain, into the plurality of subband primary signals $(e_0(m) - e_{K-1}(m))$; the subband processing module (116) includes means for implementing the adaptive algorithm for providing a plurality of subband adaptive filters (84); and the over-sampled synthesis filterbank (118, 138) includes a WOLA synthesis filterbank (138) for synthesizing the subband adaptive filters (84) to provide a time-domain filter (154) for filtering a reference signal (x(t)) in the time-domain associated with the noise.

5. A system (100a-e) as claimed in claim 4, comprising:

a second WOLA analysis filterbank (132) for transferring the reference signal (x(t)) in the time-domain, which is associated with the noise, into a plurality of subband reference signals $(x_0(m) - x_{K-1}(m))$ in the frequency-domain; the subband processing module (142) processing the output $(e_0(m) - e_{K-1}(m))$ of the first WOLA analysis filterbank (134), the output $(x_0(m) - x_{K-1}(m))$ of the second WOLA analysis filterbank (132) or a combination thereof, and providing the plurality of subband adaptive filters (84).

6. A system (100a-e) as claimed in any one of claims 1-3, wherein the first over-sampled analysis filterbank (114, 134) is implemented by a Weighted-Overlap Add (WOLA) analysis filterbank (134), and the over-sampled synthesis filterbank (118, 138) is implemented by a WOLA synthesis filterbank (138).

7. A system (100a-e) as claimed in any one of claims 1-5, wherein the subband processing module (116) is provided for implementing one or more than one delayless subband adaptive algorithm.

8. A system (100a-e) as claimed in any one of claims 1-3, 6 and 7, wherein the subband processing module (116) is adaptive or re-programmable, and models one or more than one subband transfer function associated with an application of a listening device.

9. A system (100a-e) as claimed in any one of claims 2, 3, 6 and 7, wherein:
the over-sampled synthesis filterbank (118, 138) employs WOLA synthesis process to convert a plurality of subband adaptive filters (84) from the subband processing module (116) into a time-domain filter (154) for filtering the reference signal (x(t)) in the time-domain.

10. A system (100a-e) as claimed in claim 9, wherein a time-domain output signal is provided by the output of the time-domain filter (84, 154), or a combination of the output of the time-domain filter (84, 154) and the primary signal (e(t)).

11. A system (100a-e) as claimed in claim 9, wherein:

a time-domain output signal is provided by the output of the time-domain filter (154) and the primary signal (e(t)), and the time-domain output signal is provided as input to the second over-sampled analysis filterbank (112, 132).

12. A system (100a-e) as claimed in any one of claims 1, 3 and 6, wherein the subband processing module (116) is provided for implementing one or more than one subband adaptive algorithm.

13. A system (100a-e) as claimed in any one of claims 1-3 and 6-12, wherein the subband adaptive processing (94) includes Filtered-X LMS (FX-LMS) algorithm.

14. A system (100a-e) as claimed in claim 7, wherein the delayless subband adaptive algorithm includes delayless Filtered-X LMS (FX-LMS) algorithm.

15. A system (100a-e) as claimed in claims 1 or 3, wherein the adjustable parameters of the analog ANC system (105), include loop-filter frequency, loop-gain, similar parameters or combinations thereof.

16. A system (100a-e) as claimed in any one of claims 1 and 3-5, wherein the subband processing module (116) is capable of modeling one or more than one acoustic transfer function, a transfer function for a microphone, a transfer function for a loudspeaker, or combinations thereof.

17. A method for implementing active noise cancellation, wherein

a first over-sampled analysis filterbank (114, 134), transfers a primary signal (e(t)) in a time-domain, which is associated with an acoustic signal and may be contaminated by noise, into a plurality of subband primary signals ($e_0(m)$ - $e_{K-1}(m)$) in a frequency-domain;

a subband processing module (116) for the subband primary signals ($e_0(m)$ - $e_{K-1}(m)$) implements one or more than one subband adaptive algorithm in the frequency-domain; and

an over-sampled synthesis filterbank (118, 138) transfers the outputs ($z_0(m)$ - $z_{K-1}(m)$), of the subband processing module (116) into a time-domain output signal (z(t)),

**characterized in that**

an analog active noise cancellation (ANC) system (105) performs an active noise cancellation to the primary signal (e(t)) in the time-domain and the subband processing module (116) implements the adaptive algorithm for adjusting one or more than one parameter of the analog ANC system (105).

**Patentansprüche**

1. System zur aktiven Geräuschminderung (100a-e), das umfasst:

eine erste überabgetastete Analysefilterbank (114, 134) zum Übertragen eines primären Signals (e(t)) in einem Zeitbereich, welches einem akustischen Signal zugeordnet ist und durch Rauschen kontaminiert sein kann, in eine Vielzahl von primären Teilbandsignalen ($e_0(m)$ - $e_{K-1}(m)$) in einem Frequenzbereich;

ein Teilbandverarbeitungsmodul (116) für die primären Teilbandsignale ($e_0(m)$ - $e_{K-1}(m)$), das einen oder mehr als einen adaptiven Teilbandalgorithmus in dem Frequenzbereich implementiert; und

eine überabgetastete Synthesefilterbank (118, 138) zum Übertragen der Ausgaben ($z_0(m)$ - $z_{K-1}(m)$) des Teilbandverarbeitungsmoduls (116) in ein Ausgabesignal (z(t)) im Zeitbereich,

**gekennzeichnet durch**

ein analoges aktives Geräuschminderungssystem (ANC-System) (105) zum Ausführen einer aktiven Geräuschminderung an dem primären Signal (e(t)) im Zeitbereich,

wobei das Teilbandverarbeitungsmodul (116) Mittel zum Implementieren des adaptiven Algorithmus enthält, um einen oder mehr als einen Parameter des analogen ANC-Systems (105) zu justieren.

2. System (100a-e) nach Anspruch 1, das ferner umfasst:

eine zweite überabgetastete Analysefilterbank (112, 132) zum Übertragen eines Referenzsignals (x(t)) im Zeitbereich, welches dem Rauschen zugeordnet ist, in eine Vielzahl von Referenz-Teilbandsignalen ($x_0(m)$ - $x_{K-1}(m)$) im Frequenzbereich;

wobei das Teilbandverarbeitungsmodul (116) die primären Teilbandsignale ($e_0(m)$ - $e_{K-1}(m)$), die Referenz-Teilbandsignale ($x_0(m)$ - $x_{K-1}(m)$) oder Kombinationen daraus verarbeitet und den einen oder den mehr als einen adaptiven Teilbandalgorithmus im Frequenzbereich implementiert.

3. System (100a-e) nach Anspruch 1 oder 2, das umfasst:

eine zweite überabgetastete Analysefilterbank (112, 132) zum Übertragen eines Referenzsignals (x(t)) im Zeitbereich in eine Vielzahl von Referenz-Teilbandsignalen ($x_0(m)$ - $x_{K-1}(m)$) im Frequenzbereich, wobei dem Referenzsignal (x(t)) im Zeitbereich das Rauschen zugeordnet ist;

wobei das Teilbandverarbeitungsmodul (116) die primären Teilbandsignale ($e_0(m)$ - $e_{K-1}(m)$), die Referenz-Teilbandsignale ($x_0(m)$ - $x_{K-1}(m)$) oder Kombinationen daraus verarbeitet und den einen oder den mehr als einen Parameter des analogen ANC-Systems (105) justiert.

4. System (100a-e) nach Anspruch 1, wobei

die erste überabgetastete Analysefilterband (114, 134) eine erste WOLA-Analysefilterbank (134) enthält, um das primäre Signal (e(t)) im Zeitbereich in die Vielzahl von primären Teilbandsignalen ($e_0(m)$ - $e_{K-1}(m)$) zu übertragen;

das Teilbandverarbeitungsmodul (116) Mittel zum Implementieren des adaptiven Algorithmus enthält, um eine Vielzahl von adaptiven Teilbandfiltern (84) bereitzustellen; und

die überabgetastete Synthesefilterbank (118, 138) eine WOLA-Synthesefilterbank (138) enthält, um die adaptiven Teilbandfilter (84) zu synthetisieren, um ein Zeitbereichsfilter (154) zum Filtern eines Referenzsignals (x(t)) im Zeitbereich, das dem Rauschen zugeordnet ist, bereitzustellen.

5. System (100a-e) nach Anspruch 4, das umfasst:

eine zweite WOLA-Analysefilterbank (132) zum Übertragen des Referenzsignals (x(t)) im Zeitbereich, das dem Rauschen zugeordnet ist, in eine Vielzahl von Referenz-Teilbandsignalen ($x_0(m)$ - $x_{K-1}(m)$) im Frequenzbereich;

wobei das Teilbandverarbeitungsmodul (142) die Ausgabe ($e_0(m)$ - $e_{K-1}(m)$) der ersten WOLA-Analysefilterbank (134), die Ausgabe ($x_0(m)$ - $x_{K-1}(m)$) der zweiten WOLA-Analysefilterbank (132) oder eine Kombination daraus verarbeitet und die Vielzahl der adaptiven Teilbandfilter (84) bereitstellt.

6. System (100a-e) nach einem der Ansprüche 1 - 3, wobei die erste überabgetastete Analysefilterbank (114, 134) durch eine Analysefilterbank (134) mit hinzugefügter gewichteter Überlappung (WOLA-Analysefilterbank) implementiert ist und die überabgetastete Synthesefilterbank (118, 138) durch eine WOLA-Synthesefilterbank (138) implementiert ist.

7. System (100a-e) nach einem der Ansprüche 1 - 5, wobei das Teilbandverarbeitungsmodul (116) bereitgestellt ist, um einen oder mehr als einen verzögerungsfreien adaptiven Teilbandalgorithmus zu implementieren.

8. System (100a-e) nach einem der Ansprüche 1 - 3, 6 und 7, wobei das Teilbandverarbeitungsmodul (116) adaptiv oder umprogrammierbar ist und eine oder mehr als eine Teilbandübertragungsfunktion modelliert, die einer Anwendung einer Hörvorrichtung zugeordnet ist/sind.

9. System (100a-e) nach einem der Ansprüche 2, 3, 6 und 7, wobei:

die überabgetastete Synthesefilterbank (118, 138) einen WOLA-Syntheseprozess einsetzt, um eine Vielzahl adaptiver Teilbandfilter (84) von dem Teilbandverarbeitungsmodul (116) in ein Zeitbereichsfilter (154) umzusetzen, um das Referenzsignal (x(t)) im Zeitbereich zu filtern.

10. System (100a-e) nach Anspruch 9, wobei ein Zeitbereichs-Ausgabesignal durch die Ausgabe des Zeitbereichsfilters (84, 154) oder durch eine Kombination aus der Ausgabe des Zeitbereichsfilters (84, 154) und dem primären Signal (e(t)) bereitgestellt wird.

11. System (100a-e) nach Anspruch 9, wobei:

ein Zeitbereichs-Ausgabesignal durch die Ausgabe des Zeitbereichsfilters (154) und das primäre Signal (e(t)) bereitgestellt wird, und das Zeitbereichs-Ausgabesignal als Eingabe für die zweite überabgetastete Analysefilterbank (112, 132) bereitgestellt wird.

12. System (100a-e) nach einem der Ansprüche 1, 3 und 6, wobei das Teilbandverarbeitungsmodul (116) bereitgestellt ist, um einen oder mehr als einen adaptiven Teilbandalgorithmus zu implementieren.

13. System (100a-e) nach einem der Ansprüche 1 - 3 und 6 - 12, wobei die adaptive Teilbandverarbeitung (94) einen gefilterten-X LMS-Algorithmus (FX-LMS-Algorithmus) enthält.

14. System (100a-e) nach Anspruch 7, wobei der verzögerungsfreie adaptive Teilbandalgorithmus einen verzögerungsfreien gefilterten-X LMS-Algorithmus (FX-LMS-Algorithmus) enthält.

15. System (100a-e) nach Anspruch 1 oder 3, wobei die justierbaren Parameter des analogen ANC-Systems (105) eine Schleifenfilterfrequenz, eine Schleifenverstärkung, ähnliche Parameter oder Kombinationen daraus enthalten.

16. System (100a-e) nach einem der Ansprüche 1 und 3 - 5, wobei das Teilbandverarbeitungsmodul (116) in der Lage ist, eine oder mehr als eine akustische Übertragungsfunktion, eine Übertragungsfunktion für ein Mikrofon, eine Übertragungsfunktion für einen Lautsprecher oder Kombinationen daraus zu modellieren.

17. Verfahren zum Implementieren einer aktiven Geräuschminderung, wobei eine erste überabgetastete Analysefilterbank (114, 134) ein primäres Signal (e(t)) in einem Zeitbereich, welches einem akustischen Signal zugeordnet ist und durch Rauschen kontaminiert sein kann, in eine Vielzahl von primären Teilbandsignalen ($e_0$(m) - $e_{K-1}$(m)) in einem Frequenzbereich überträgt; ein Teilbandverarbeitungsmodul (116) für die primären Teilbandsignale ($e_0$(m) - $e_{K-1}$(m)) einen oder mehr als einen adaptiven Teilbandalgorithmus im Frequenzbereich implementiert; und eine überabgetastete Synthesefilterbank (118, 138) die Ausgaben ($z_0$(m) - $z_{K-1}$(m)) des Teilbandverarbeitungsmoduls (116) in ein Zeitbereichs-Ausgabesignal (z(t)) überträgt,

**dadurch gekennzeichnet, dass**

ein analoges aktives Geräuschminderungssystem (ANC-System) (105) eine aktive Geräuschminderung an dem primären Signal (e(t)) im Zeitbereich ausführt und das Teilbandverarbeitungsmodul (116) den adaptiven Algorithmus zum Justieren eines oder mehr als eines Parameters des analogen ANC-Systems (105) implementiert.

## Revendications

1. Système de suppression active du bruit (100a-e), comprenant :

un premier banc de filtres d'analyse suréchantillonnés (114, 134), pour transférer un signal primaire (e(t)) dans un domaine temporel, qui est associé à un signal acoustique et peut être contaminé par du bruit, dans une pluralité de signaux primaires en sous-bandes ($e_0$(m) - $e_{k-1}$(m)) dans un domaine fréquentiel ; un module de traitement de sous-bandes (116) pour les signaux primaires en sous-bandes ($e_0$(m) - $e_{k-1}$(m)), mettant en oeuvre un ou plusieurs algorithmes adaptatifs de sous-bandes dans le domaine fréquentiel ; et un banc de filtres de synthèse suréchantillonnés (118, 138) pour transférer les sorties ($z_0$(m) - $z_{K-1}$(m)) du module de traitement de sous-bandes (116) dans un signal de sortie (z(t)) dans le domaine temporel,

**caractérisé par**

un système analogique de suppression active du bruit ("active noise cancellation" ou ANC) (105) pour effectuer une suppression active du bruit sur le signal primaire (e(t)) dans le domaine temporel, le module de traitement de sous-bandes (116) incluant un moyen pour mettre en oeuvre l'algorithme adaptatif pour régler un ou plusieurs paramètres du système analogique ANC (105).

2. Système (100a-e) selon la revendication 1, comprenant en outre :

un second banc de filtres d'analyse suréchantillonnés (112, 132) pour transférer un signal de référence (x(t)) dans le domaine temporel, qui est associé au bruit, dans une pluralité de signaux de référence en sous-bandes ($x_0$(m) - $x_{K-1}$(m)) dans le domaine fréquentiel ; le module de traitement de sous-bandes (116) traitant les signaux primaires en sous-bandes ($e_0$(m) - $e_{K-1}$(m)), les signaux de référence en sous-bandes ($x_0$(m) - $x_{K-1}$(m)) ou des combinaisons de ceux-ci, et mettant en oeuvre lesdits un ou plusieurs algorithmes adaptatifs de sous-bandes dans le domaine fréquentiel.

3. Système (100a-e) selon la revendication 1 ou 2, comprenant :

un second banc de filtres d'analyse suréchantillonnés (112, 132) pour transférer un signal de référence (x(t)) dans le domaine temporel dans une pluralité de signaux de référence en sous-bandes ($x_0$(m) - $x_{K-1}$(m)) dans le domaine fréquentiel, le signal de référence (x(t)) dans le domaine temporel étant associé au bruit ; le module de traitement de sous-bandes (116) traitant les signaux primaires en sous-bandes ($e_0$(m) - $e_{K-1}$(m)), les signaux de référence en sous-bandes ($x_0$(m) - $x_{K-1}$(m)) ou des combinaisons de ceux-ci, et réglant lesdits un ou plusieurs paramètres du système analogique ANC (105).

4. Système (100a-e) selon la revendication 1, dans lequel

le premier banc de filtres d'analyse suréchantillonnés (114, 134) inclut un premier banc de filtres d'analyse à addition par chevauchement pondérée ("weighted overlap-add" ou WOLA) (134) pour transférer le signal primaire (e(t)) dans le domaine temporel, dans la pluralité de signaux primaires en sous-bandes ($e_0$(m) - $e_{K-1}$(m)) ; le module de traitement de sous-bandes (116) inclut un moyen pour mettre en oeuvre l'algorithme adaptatif pour fournir une pluralité de filtres adaptatifs de sous-bandes (84) ; et le banc de filtres de synthèse suréchantillonnés (118, 138) inclut un banc de filtres de synthèse WOLA (138) pour synthétiser les filtres adaptatifs de sous-bandes (84) afin de fournir un filtre en domaine temporel (154) pour filtrer un signal de référence (x(t)) dans le domaine temporel associé au bruit.

5. Système (100a-e) selon la revendication 4, comprenant :

un second banc de filtres d'analyse WOLA (132) pour transférer le signal de référence (x(t)) dans le domaine temporel, qui est associé au bruit, dans une pluralité de signaux de référence en sous-bandes ($x_0$(m) - $x_{K-1}$(m)) dans le domaine fréquentiel ;

le module de traitement de sous-bandes (142) traitant la sortie ($e_0(m)$ - $e_{K-1}(m)$) du premier banc de filtres d'analyse WOLA (134), la sortie ($x_0(m)$ - $x_{K-1}(m)$) du second banc de filtres d'analyse WOLA (132) ou une combinaison de celles-ci, et fournissant la pluralité de filtres adaptatifs de sous-bandes (84).

6. Système (100a-e) selon l'une quelconque des revendications 1 à 3, dans lequel le premier banc de filtres d'analyse suréchantillonnés (114, 134) est mis en oeuvre par un banc de filtres d'analyse à chevauchement pondéré et addition (WOLA) (134) et le banc de filtres de synthèse suréchantillonnés (118, 138) est mis en oeuvre par un banc de filtres de synthèse WOLA (138).

7. Système (100a-e) selon l'une quelconque des revendications 1 à 5, dans lequel le module de traitement de sous-bandes (116) est prévu pour mettre en oeuvre un ou plusieurs algorithmes adaptatifs de sous-bandes sans retard.

8. Système (100a-e) selon l'une quelconque des revendications 1-3, 6 et 7, dans lequel le module de traitement de sous-bandes (116) est adaptatif ou reprogrammable et modélise une ou plusieurs fonctions de transfert de sous-bandes associées à une application d'un dispositif d'écoute.

9. Système (100a-e) selon l'une quelconque des revendications 2, 3, 6 et 7, dans lequel :

le banc de filtres de synthèse suréchantillonnés (118, 138) utilise un procédé de synthèse WOLA pour convertir une pluralité de filtres adaptatifs de sous-bandes (84) du module de traitement de sous-bandes (116) en un filtre en domaine temporel (154) pour filtrer le signal de référence ($x(t)$) dans le domaine temporel.

10. Système (100a-e) selon la revendication 9, dans lequel un signal de sortie en domaine temporel est fourni par la sortie du filtre en domaine temporel (84, 154) ou une combinaison de la sortie du filtre en domaine temporel (84, 154) et du signal primaire ($e(t)$).

11. Système (100a-e) selon la revendication 9, dans lequel :

un signal de sortie en domaine temporel est fourni par la sortie du filtre en domaine temporel (154) et le signal primaire ($e(t)$), et

le signal de sortie en domaine temporel est fourni comme entrée au second banc de filtres d'analyse suréchantillonnés (112, 132).

12. Système (100a-e) selon l'une quelconque des revendications 1, 3 et 6, dans lequel le module de traitement de sous-bandes (116) est prévu pour mettre en oeuvre un ou plusieurs algorithmes adaptatifs de sous-bandes.

13. Système (100a-e) selon l'une quelconque des revendications 1 à 3 et 6 à 12, dans lequel le traitement adaptatif de sous-bandes (94) inclut un algorithme LMS filtré sur X (FX-LMS).

14. Système (100a-e) selon la revendication 7, dans lequel l'algorithme adaptatif de sous-bandes sans retard inclut un algorithme LMS filtré sur X (FX-LMS) sans retard.

15. Système (100a-e) selon la revendication 1 ou 3, dans lequel les paramètres réglables du système analogique ANC (105) incluent une fréquence de filtre à boucle, un gain de boucle, des paramètres similaires ou des combinaisons de ceux-ci.

16. Système (100a-e) selon l'une quelconque des revendications 1 et 3 à 5, dans lequel le module de traitement de sous-bandes (116) est capable de modéliser une ou plusieurs fonctions de transfert acoustiques, une fonction de transfert pour un microphone, une fonction de transfert pour un haut-parleur ou des combinaisons de celles-ci.

17. Procédé pour mettre en oeuvre une suppression active du bruit, dans lequel

un premier banc de filtres d'analyse suréchantillonnés (114, 134) transfère un signal primaire ($e(t)$) dans un domaine temporel, qui est associé à un signal acoustique et peut être contaminé par du bruit, dans une pluralité de signaux primaires en sous-bandes ($e_0(m)$ - $e_{K-1}(m)$) dans un domaine fréquentiel ;

un module de traitement de sous-bandes (116) pour les signaux primaires en sous-bandes ($e_0(m)$ - $e_{K-1}(m)$) met en oeuvre un ou plusieurs algorithmes adaptatifs de sous-bandes dans le domaine fréquentiel ; et

un banc de filtres de synthèse suréchantillonnés (118, 138) transfère les sorties ($z_0(m)$ - $z_{K-1}(m)$) du module de traitement de sous-bandes (116) dans un signal de sortie ($z(t)$) dans le domaine temporel,

**caractérisé en ce**

**qu'**un système analogique de suppression active du bruit (ANC) (105) effectue une suppression active du bruit sur le signal primaire ($e(t)$) dans le domaine temporel et

**que** le module de traitement de sous-bandes (116) met en oeuvre l'algorithme adaptatif pour régler un ou plusieurs paramètres du système analogique ANC (105).

Noise
source ● x(t)  2

Error
Microphone  Loudspeaker
6  10

e(t)  y(t)

Analog ANC  z(t)  ⊕  s(t)
4  8

(a)

12  16  14

x(t)  d(t)

Noise  P(s)  ⊕  Q(s)
source

e(t)  y(t)

Analog ANC  z(t)  ⊕  s(t)
4  8

(b)

Fig. 1

EP 1 638 079 B1

**FX-LMS with reference microphone**

Acoustic domain

Noise Source

Reference Mic

Error Mic

Fig. 2

EP 1 638 079 B1

Subband FX-LMS with reference microphone, 3 AFBs

Fig. 3

Fig. 4

**Subband FX-LMS with reference microphone, 2 AFBs**

50a

SFB — 60

$W_i(z)$ — 56

NLMS — 58

$\hat{Q}_i(z)$ — 54

SAP 91

AFB — 52

AFB — 52

A/D — 22

A/D — 24

Reference Mic

Error Mic

Acoustic domain

Noise Source

P(s) — 12

Q(s) — 14

16

D/A — 32

8

$z(n)$, $z_i(m)$, $x_i(m)$, $x_i'(m)$, $e_i(m)$, $x(n)$, $e(n)$, $x(t)$, $d(t)$, $y'(t)$, $y(t)$, $s(t)$, $z(t)$, $e(t)$

FX-LMS without reference microphone

Fig. 5

Fig. 6

Fig. 7

**Delayless Subband FX-LMS without reference microphone**

Fig. 8

Subband FX-LMS with reference microphone, and analog ANC

Fig. 9

EP 1 638 079 B1

## Subband FX-LMS without reference microphone, with analog ANC

100b

Fig. 10

EP 1 638 079 B1

Subband WOLA-based FX-LMS with reference microphone, with analog ANC

100c

SFB

WOLA Synthesis — 138

$z(n)$

$z_0(m)$ ... $z_{K-1}(m)$

SUBBAND PROCESSING

116

$X_0(m)$ ... $x_{K-1}(m)$ $e_0(m)$ ... $e_{K-1}(m)$

AFB

WOLA Analysis — 132

WOLA Analysis

AFB — 134

Reference Mic $x(n)$

A/D — 22

Error Mic 24 $e(n)$

A/D

105

Analog ANC

Acoustic domain

Noise Source $x(t)$

12 — P(s)

$d(t)$ 16 — (+)

$y'(t)$ 14 — Q(s)

$y(t)$ 8

$f(t)$

32

D/A

$s(t)$ (+) $z(t)$

Fig. 11

Subband FX-LMS without reference
microphone, with analog ANC

Fig. 12

EP 1 638 079 B1

Subband WOLA-based FX-LMS with reference
microphone, with analog ANC

100e

SFB

WOLA
Synthesis

138

$w_0(m)$ ... $w_{K-1}(m)$

SUBBAND
PROCESSING

116

$x_0(m)$ ... $x_{K-1}(m)$   $e_0(m)$ ... $e_{K-1}(m)$

AFB

WOLA
Analysis

WOLA
Analysis

AFB

134

Reference Mic 132   $x(n)$

A/D   22

Error Mic 24   $e(n)$

A/D

Acoustic
domain

Noise
Source

$x(t)$   12

$P(s)$

$d(t)$   16

$y'(t)$   14

$Q(s)$

$e(t)$

$y(t)$

$s(t)$

$z(t)$

$f(t)$

Analog ANC   105

32

D/A

W (z)   84

$w(n)$

8

Fig. 13

EP 1 638 079 B1

**AFB**

142

**SFB**

140a

$x_0(m)$

$z(m)$
0

$z(n)$

$h_0(n)$ → ↓R → APB → ↑R → $f_0(n)$ → ⊕ → 

**x(n)**

Reference
Input

$x_{K-1}(m)$

$z_{K-1}(m)$

$h_{K-1}(n)$ → ↓R → APB → ↑R → $f_{K-1}(n)$

112

142

118

**AFB**

114

$e_0(m)$

$h_0(n)$ → ↓R

**e(n)**

Primary
Input

$e_{K-1}(m)$

$h_{K-1}(n)$ → ↓R

Fig. 14

EP 1 638 079 B1

$x_k(m)$

146

| Adaptation Algorithm | $W_i(m)$ |

144

$e_k(m)$

$z_k(m)$

(a)

$x_k(m)$

144

$W_i(m)$ | Adaptation Algorithm |

146

$e_k(m)$ −

+

148

$z_k(m)$

(b)

Fig. 15

Fig. 16

Fig. 17

Fig. 18

EP 1 638 079 B1

Fig. 19

EP 1 638 079 B1

Fig. 20

EP 1 638 079 B1

Fig. 21

Delayless Subband WOLA-based FX-LMS without reference microphone

Fig. 22

EP 1 638 079 B1

**FIG.23:** Delayless SAF system using oversampled filterbanks, employing weight transform for time-filter reconstruction.

EP 1 638 079 B1

**Fig. 24**  Reconstruction of TAF through WOLA synthesis of the SAFs

EP 1 638 079 B1

m=0,1, M-1

$W_k(m)$

SAF matrix

162

0

K-1

input

164

166

K-point
IFFT

168

*Circular shift*

160

(1:K)  ...  (1:K)  (1:K)

170

Synthesis f(1:Ls)
Window

172

174

Overlap-Add

178

Output Buffer(1:Ls)

zeros

176

1   R

182

± sign sequencer

180

output

184

W(1:R)

**Fig. 25**

**Fig. 26**

Oversampled SAF system applied to echo cancellation.

(A)   Time-domain echo plant, and the reconstructed plant with SGS-PAP adaptation, for D=1,8 ,

**FIG. 27**      (B)   error in reconstructed TAFs for D=1 and (C) error for D=8.

EP 1 638 079 B1

**FIG. 28**     ERLE results for SGS-PAP adaptation with D=1,8, for Figure 24 and 26.

Fig. 29

* Real part
● Imaginary part

subband 0

subband 1

subband 2

amplitude

subband 3

Subband Time Sample

EP 1 638 079 B1

**Fig. 30**

Fig. 31

EP 1 638 079 B1

Fig.32

Fig. 33

amplitude

Time Sample

Fig. 34(a)

Fig. 34(b)

Fig. 35

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5475761 A
- US 5699436 A
- US 5815582 A
- US 6418227 B1
- US 5991418 B1
- US 5940519 A, Kuo
- US 6069959 A
- US 6118878 A
- CA 2397080 A1
- CA 2410749 A1
- CA 2437477 A1
- CA 2397084
- US 5440642 A, Denenberg
- US 20040037430 A1
- US 4965832 A
- US 6278786 B1
- US 5329587 A, Morgan

- US 6661895 B1, Jin
- US 6236731 B
- US 6240192 B
- US 6115478 A
- US 20030198357 A
- US 10214056 B
- US 20030108214 A
- US 20040071284 A
- US 10214057 B
- US 10642847 B
- CA 2481629
- US 6240192 B1
- US 6236731 B1
- US 6115478 B1

**Non-patent literature cited in the description**

- **MORGAN.** A delayless subband adaptive filter structure. *IEEE Trans. on Signal Proc.,* August 1995, vol. 43, 1819-1830
- **J. HUO et al.** New weight transform schemes for delayless subband adaptive filtering. *Proc. of IEEE Global Telecom. Conf.,* 2001, 197-201
- **L. LARSON et al.** A new subband weight transform for delayless subband adaptive filtering structures. *Proc. of IEEE DSP workshop,* 201-206
- **N. HIRAYAMA ; H. SAKAI.** Analysis of a delayless subband adaptive filter. *Proc, of ICASSP,* 1997, 2329-2332
- **N, HIRAYAMA et al.** Delayless subband adaptive filtering using the hadamard transform. *IEEE Trans. on Signal Proc.,* June 1999, vol. 47 (6), 1731-1734
- **R. MERCHED et al.** A Delayless alias-free subband adaptive filter structure. *Proc. of IEEE Int. Symp. On Circuits and Systems,* 09 June 1997, 2329-2332
- **P. S. R. DINIZ et al.** Analysis of a delayless subband adaptive filter structure. *Proc. of ICASSP,* 1998, 1661-1664

- **R. MERCHED et al.** A new delayless subband adaptive filter structure. *IEEE Trans. on Signal Proc.,* June 1999, vol. 47 (6), 1580-1591
- **SEN M. KUO ; DENNIS R. MORGAN.** Active Noise Control: A Tutorial Review. *Proceedings of the IEEE,* June 1999, vol. 87, 943-973
- **H. SHEIKHZADEH et al.** Performance Limitations of a New Subband Adaptive System for Noise and Echo Reduction. *Proc. Of IEEE ICECS,* 2003
- **P. L. DE LEON II et al.** Experimental Results with Increased Bandwidth Analysis Filters in Oversampled, Subband Acoustic Echo Cancellers. *IEEE Sig. Proc. Letters,* January 1995, vol. 2, 1-3
- **ALBU et al.** The Gauss-Seidel Pseudo Affine Projection Algorithm and its Application for Echo Cancellation. *37th Asilomar Conf. Sig. Sys. & Comp.,* November 2003
- **H. SHEILCHZADEH et al.** Partial update subband implementation of complex pseudo-affine projection algorithm on oversampled filterbanks. *ICASSP, 2005 IEEE International Conference on Acoustics, Speech, and Signal Processing,* 18 March 2005
- **R.E. CROCHIERE et al.** Multirate digital signal processing. Prentice-Hall, 1983